# FASCICULE DE BREVET EUROPEEN

(11) **EP 4 505 512 B1**
(45) Date de publication et mention de la délivrance du brevet: **22.04.2026**
(21) Numéro de dépôt: 23716542.8
(22) Date de dépôt: 03.04.2023
(51) Int. Cl.: H01L 21/768, H01L 23/48

(54) **SUBSTRAT COMPRENANT DES VIAS ET PROCÉDÉS DE FABRICATION ASSOCIÉS**
SUBSTRAT MIT VIAS UND ZUGEHÖRIGE HERSTELLUNGSVERFAHREN
SUBSTRATE COMPRISING VIAS AND ASSOCIATED MANUFACTURING METHODS

(30) Priorité: 06.04.2022 FR 2203164
(43) Date de publication de la demande: 12.02.2025
(73) Titulaire: Commissariat à l'Energie Atomique et aux Energies Alternatives, 75015 Paris (FR); SOITEC, 38190 Bernin (FR)
(72) Inventeur: CHARBONNIER, Jean, 38054 Grenoble Cedex 09 (FR); COUDRAIN, Perceval, 38054 Grenoble Cedex 09 (FR); COUTIER, Caroline, 38054 Grenoble Cedex 09 (FR); GHYSELEN, Bruno, 38170 Seyssinet Pariset (FR); SALVETAT, Thierry, 38054 Grenoble Cedex 09 (FR)
(74) Mandataire: Hautier IP
(86) Numéro de dépôt international: PCT/EP2023/058705
(87) Numéro de publication internationale: WO 2023/194318

(56) Documents cités:
- WO-A1-2017/212160
- US-A1- 2009 008 747
- US-A1- 2020 350 198

## Description

### DOMAINE TECHNIQUE DE L'INVENTION

La présente invention concerne le domaine des substrats destinés à fabriquer des dispositifs électroniques et plus particulièrement des dispositifs microélectroniques, ces substrats permettant *in fine* un raccordement électrique et mécanique d'éléments électriques de composants. L'invention trouve pour application avantageuse, mais non limitative, la fabrication de dispositifs microélectroniques, et par exemple de dispositifs microélectroniques pour des applications de calculs.

### ETAT DE LA TECHNIQUE

Document WO2017/212160 A1 divulgue une structure pour application radiofréquence. Document US2009/0008747 A1 divulgue un dispositif semi-conducteur comprenant une électrode de connexion.

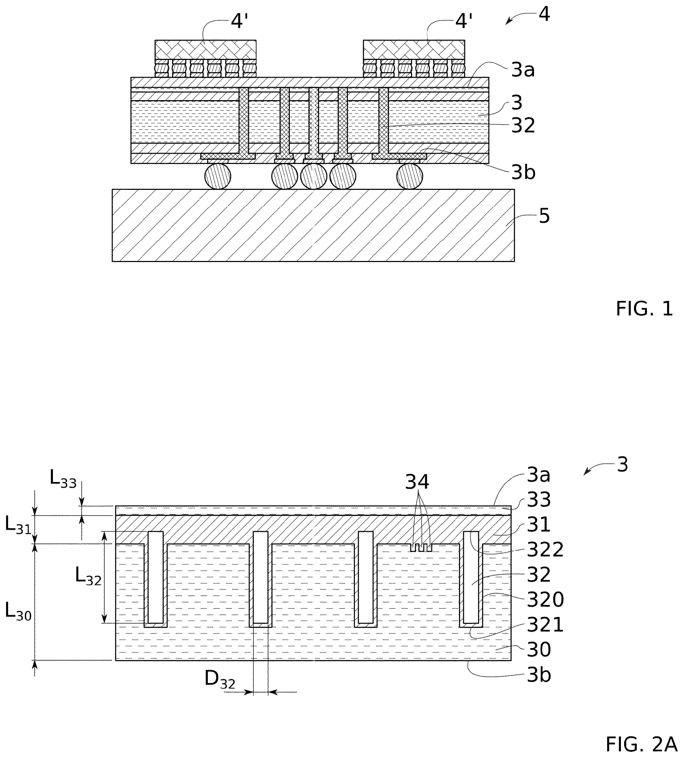

Il existe un intérêt pour fabriquer, comme par exemple illustré par la figure 1, des assemblages de composants 4' sur des substrats 3 comprenant des vias 32 pour former des contacts traversants afin de pouvoir interconnecter ces composants en face avant 3a et en face arrière 3b du substrat 3, pour obtenir un dispositif microélectronique 4. Les composants 4' peuvent ainsi être connectés à un circuit imprimé par exemple par le biais d'un boîtier 5. Ces substrats 3 peuvent notamment être des substrats semi-conducteurs, par exemple de type semi-conducteur sur isolant, et notamment silicium-sur-isolant SOI (abrégé de l'anglais *Silicon-On-Insulator*).

La gravure et la métallisation de ces vias 32 (communément désignés TSV, abrégé de l'anglais *Through-Silicon-Via* pour les substrats à base de silicium) sont des étapes de procédé assez spécifiques et souvent réalisées chez les assembleurs (communément désignés OSAT, de l'anglais *Outsourced Semi-conductor Assembly and Test)* et non les fondeurs.

On distingue deux types de vias selon leur moment de fabrication dans la chaîne de fabrication d'un dispositif microélectronique. Les vias dit « TSV-middle » sont généralement fabriqués en milieu de procédé, après la fabrication des motifs d'un composant lors du *Front-end-of-line* (abrégé FEOL, que l'on peut traduire par début de ligne de fabrication) mais avant le dépôt des couches métalliques du *Back-end-of-line* (abrégé BEOL, que l'on peut traduire par fin de ligne de fabrication). Cela demande généralement un transfert du substrat et des composants du fondeur à l'assembleur pour la fabrication des vias, ensuite un retour au fondeur pour les étapes du BEOL, et enfin encore un transfert à l'assembleur pour finaliser le procédé. Ces étapes de fabrication sont très contraintes en termes de planéité, de contamination, ce qui est peu compatible avec ces allers-retours entre fondeur et assembleur.

Les vias « TSV-last » peuvent être fabriqués en fin de procédé, après les étapes du FEOL et du BEOL. Cela demande généralement un seul transfert du fondeur à l'assembleur, après les étapes du BEOL. Toutefois, les géométries de vias ainsi réalisables sont limitées. Notamment, la densité de vias pouvant être obtenue est limitée. Ceci est particulièrement limitant pour certaines applications telles que pour le calcul.

Il existe donc un besoin pour obtenir ces structures sans dépendre des autres étapes de fabrication de la chaîne.

Un objet de la présente invention est donc de faciliter la fabrication de vias dans un dispositif microélectronique.

Les autres objets, caractéristiques et avantages de la présente invention apparaîtront à l'examen de la description suivante et des dessins d'accompagnement. Il est entendu que d'autres avantages peuvent être incorporés.

### RESUME DE L'INVENTION

Pour atteindre cet objectif, selon un mode de réalisation on prévoit un substrat comprenant :
- une première couche à base, de préférence faite, d'un matériau semi-conducteur,
- une deuxième couche surmontant la première couche.

Avantageusement, le substrat comprend une pluralité de vias creux enterrés s'étendant depuis la deuxième couche sur une portion de la première couche, chaque via étant délimité par une paroi latérale, une paroi de fond, et une paroi supérieure opposée à la paroi de fond.

Ainsi, le substrat comprend des vias creux non-débouchants pour le remplissage ultérieur par un organe conducteur électriquement ou semi-conducteur. Ceci permet de fournir les vias creux indépendamment des autres étapes de réalisation d'un dispositif microélectronique. Le substrat comprenant les vias creux enterrés peut être utilisé pour réaliser le dépôt de couches, par exemple du FEOL et du BEOL, puis les vias creux peuvent être ouverts pour réaliser l'organe électriquement conducteur ou semi-conducteur désiré, par exemple des interconnexions électriques. En outre, les vias étant fabriqués au préalable, les géométries des vias ne sont pas limitées.

Ceci présente plusieurs avantages. Ces vias creux sont compatibles avec les étapes de FEOL se déroulant à haute température, contrairement aux solutions existantes mettant en œuvre des vias métallisés, par exemple en cuivre ou en tungstène.

On comprend donc que la fabrication des vias est facilitée, notamment au regard des autres étapes de fabrication d'un dispositif microélectronique. La fabrication des vias remplis par l'organe électriquement conducteur ou semi-conducteur, est plus particulièrement facilitée.

Selon un exemple, au moins la paroi de fond et la paroi latérale sont en matériau diélectrique. Les parois en matériaux diélectriques étant formées au préalable, elles permettent une bonne isolation des vias une fois rempli par le matériau conducteur ou semi-conducteur, tout en étant compatibles avec les étapes du FEOL ou de montage temporaire d'un support. Ceci est particulièrement avantageux lorsque le facteur de forme des vias est supérieur ou égal à 10, pour lequel il est plus simple de réaliser ces parois préalablement à la fabrication d'un dispositif microélectronique.

Un deuxième aspect concerne un procédé de fabrication du substrat selon le premier aspect, comprenant :
- une fourniture d'un sous-substrat support comprenant au moins une première couche à base, de préférence faite, d'un matériau semi-conducteur, le sous-substrat support présentant une surface exposée,
- une gravure d'une pluralité de vias de sorte que les vias s'étendent depuis la surface exposée sur une portion de la première couche, chaque via étant délimité par une paroi latérale et une paroi de fond,
- une fourniture d'un sous-substrat donneur comprenant une couche superficielle présentant une surface exposée,
- un assemblage du sous-substrat support et du sous-substrat donneur par leurs surfaces exposées, de façon à recouvrir les vias, chaque via étant alors délimité par la paroi latérale, la paroi de fond, et une paroi supérieure opposée à la paroi de fond.

Ce procédé permet ainsi la fabrication des vias creux enterrés sur le substrat. Ce procédé présente les effets et avantages décrits relativement au premier aspect.

Un troisième aspect concerne un procédé de fabrication d'un dispositif microélectronique comprenant :
- une fourniture d'un substrat selon le premier aspect ou d'un substrat fabriqué par le procédé selon le deuxième aspect, présentant une surface exposée avant et une surface exposée arrière,
- une formation d'au moins une portion de couche du dispositif par un dépôt, sur la surface exposée avant du substrat, de ladite portion, et/ou une gravure de la surface exposée avant du substrat, configurée de façon à former ladite portion,
- au niveau d'au moins un via, une gravure par la surface exposée arrière du substrat, dans laquelle une paroi parmi la paroi supérieure et la paroi de fond de l'au moins un via est gravée de façon à déboucher dans le via, puis poursuivre la gravure pour atteindre l'au moins une portion de couche du dispositif, pour former une cavité,
- le dépôt d'un organe électriquement conducteur ou semi-conducteur de façon à remplir la cavité.

Ainsi, le substrat fourni permet la formation d'un dispositif microélectronique, puis l'ouverture des vias creux enterrés pour réaliser l'organe électriquement conducteur ou semi-conducteur voulu. Cela peut être réalisé de façon facilitée par rapport aux solutions existantes.

### BREVE DESCRIPTION DES FIGURES

Les buts, objets, ainsi que les caractéristiques et avantages de l'invention ressortiront mieux de la description détaillée de modes de réalisation de cette dernière, illustrés par les dessins d'accompagnement suivants.
La figure 1 représente une vue en coupe transversale d'un dispositif microélectronique comprenant un substrat comprenant des vias, selon un exemple général de l'état de la technique.
Les figures 2A à 2C représentent des vues en coupe transversale et du dessus du substrat selon deux exemples de réalisation.
Les figures 3A et 3B représentent chacune une vue en coupe transversale du substrat selon deux autres exemples de réalisation, dans lesquels le substrat comprend des rainures entourant les vias.
La figure 3C représente une vue du dessus du substrat illustré selon l'une quelconque parmi les figures 3A et 3B.
Les figures 4A à 9C représentent des vues en coupe transversale des étapes du procédé de fabrication du substrat selon des exemples de réalisations, parmi lesquelles :
   - les figures 6A et 6B représentent des vues en coupe transversale de la gravure et de la formation des parois en matériau diélectrique, selon un exemple de réalisation,
   - la figure 6C représente une vue en coupe transversale de la gravure des vias, selon un autre exemple de réalisation,
   - les figures 7A à 7C représentent des vues en coupe transversale de la gravure et de la formation des parois en matériau diélectrique, selon deux autres exemples de réalisation dans lesquels le substrat comprend des rainures entourant les vias.
   - les figures 8A et 8B représentent des vues en coupe transversale de l'assemblage du sous-substrat support et du sous-substrat donneur selon un exemple de réalisation,
   - les figures 9A et 9B représentent des vues en coupe transversale de l'assemblage du sous-substrat support et du sous-substrat donneur selon un autre exemple de réalisation,
   - la figure 9C représente une vue en coupe transversale de l'assemblage du sous-substrat support et du sous-substrat donneur selon un autre exemple de réalisation.
Les figures 10 à 17 représentent des vues en coupe transversale des étapes du procédé de fabrication du dispositif microélectronique selon des exemples de réalisations, parmi lesquels :

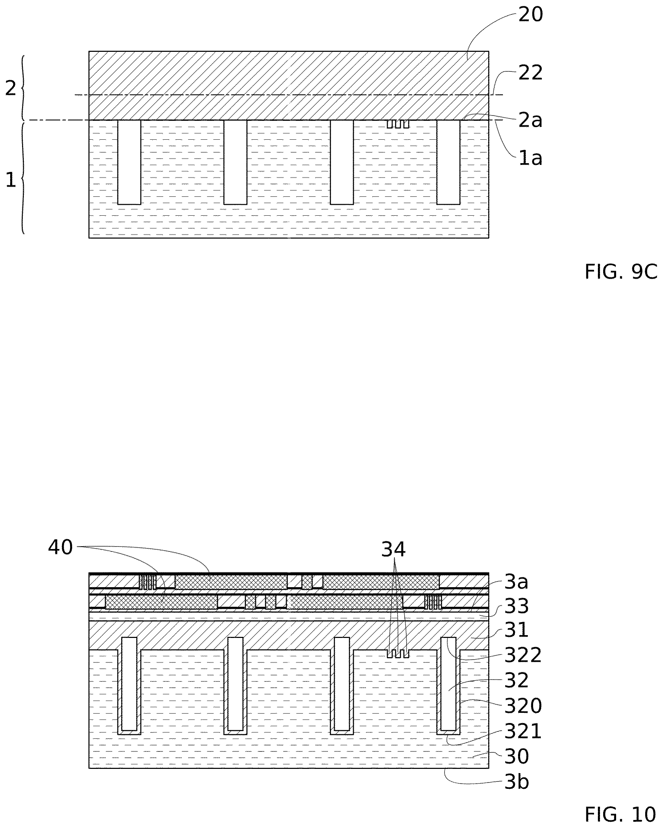

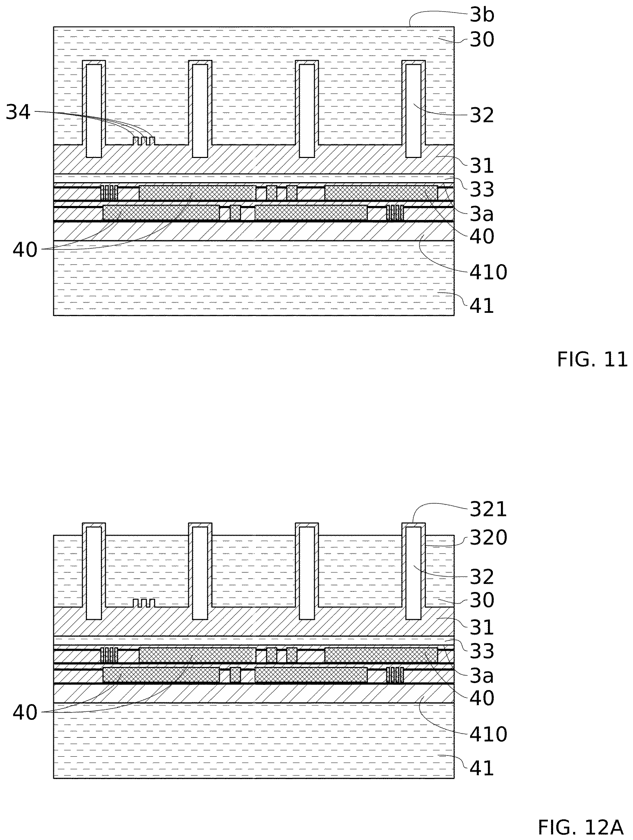

   - les figures 10 et 11 représentent des vues en coupe transversale du dépôt de portion de couche de dispositif et du montage d'un support, selon un exemple de réalisation,
   - les figures 12A à 12D représentent des vues en coupe transversale d'un exemple de sélection des vias à graver,

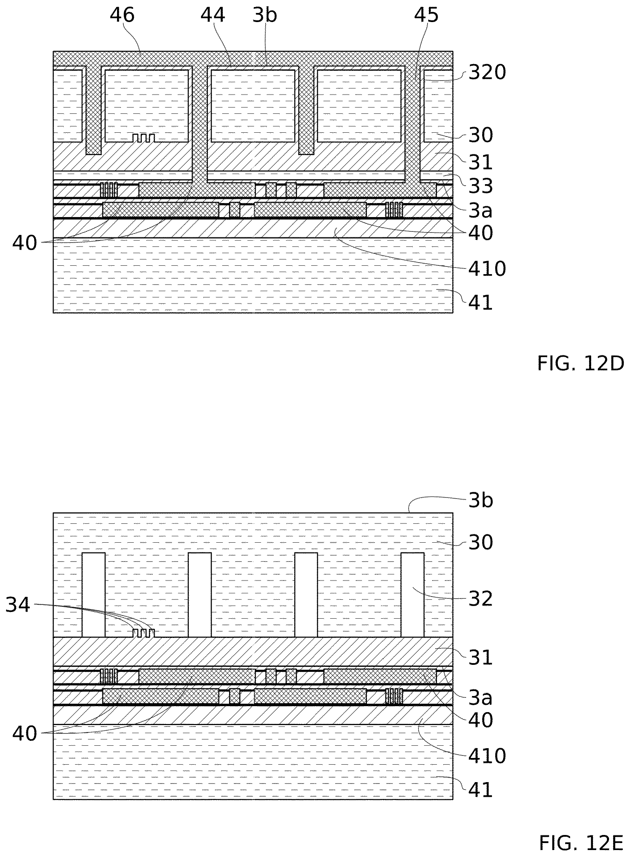

   - les figures 12E à 12H représentent des vues en coupe transversale d'un deuxième exemple de sélection des vias à graver,

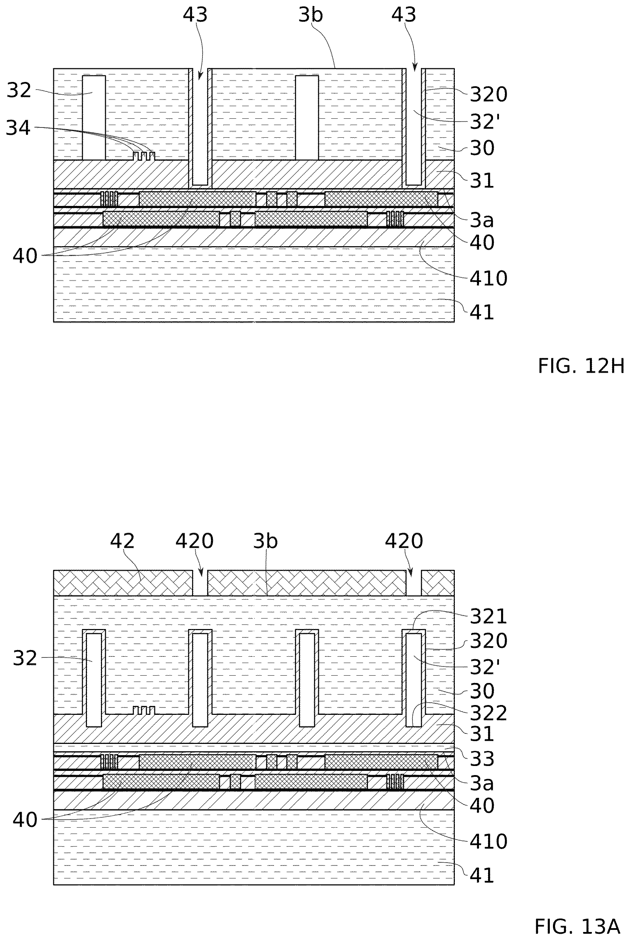

   - les figures 13A à 13C représentent des vues en coupe transversale d'un troisième exemple de sélection des vias à graver,

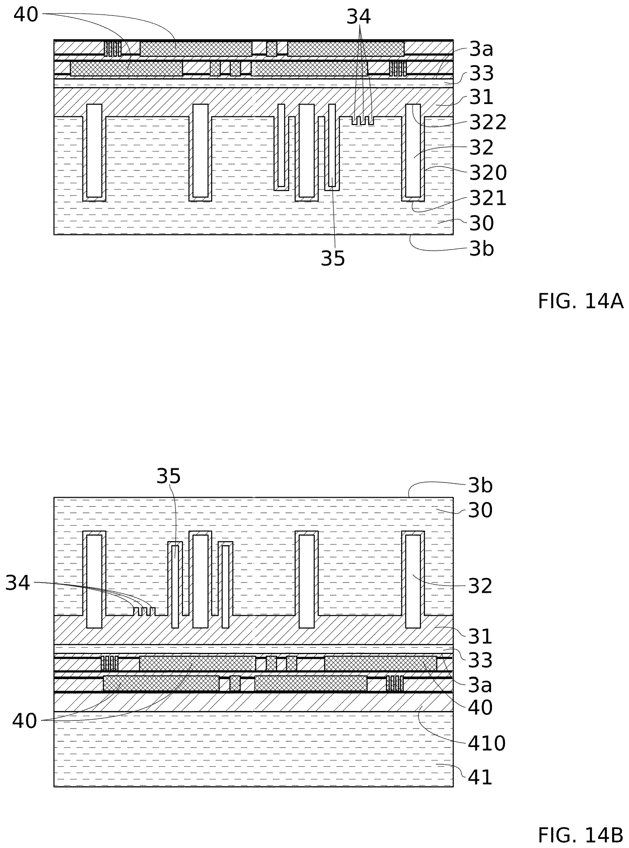

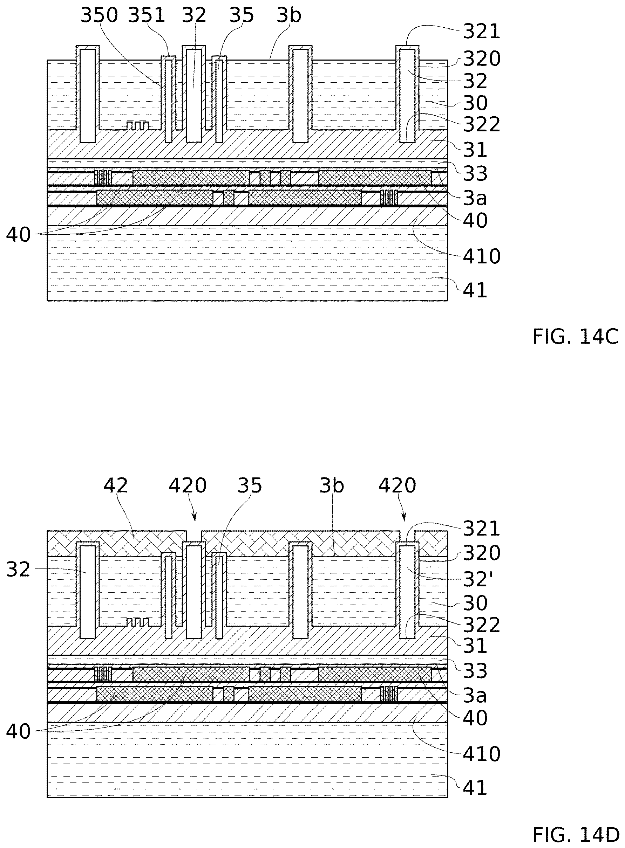

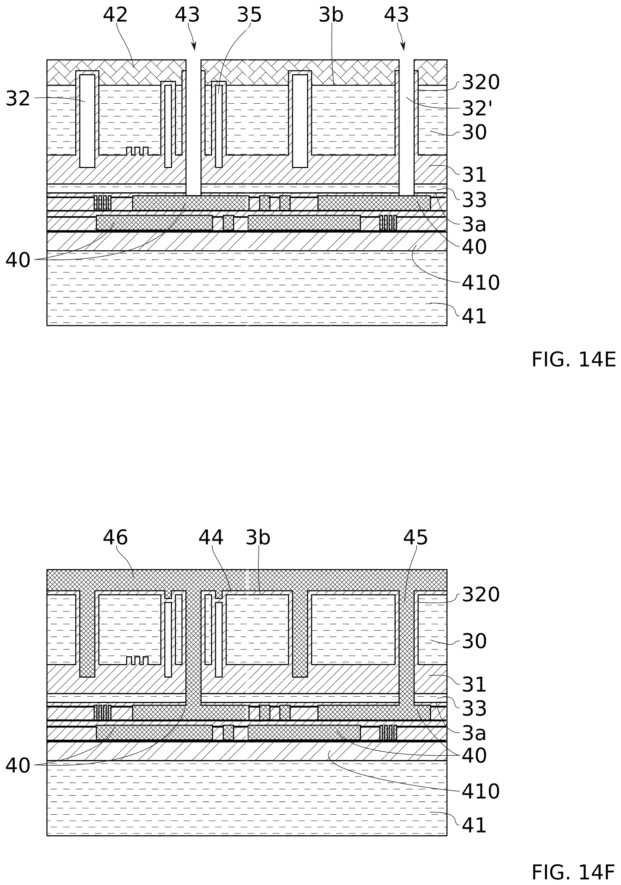

   - les figures 14A à 14F représentent des vues en coupe transversale d'un exemple du procédé dans lequel le substrat comprend des rainures entourant les vias,

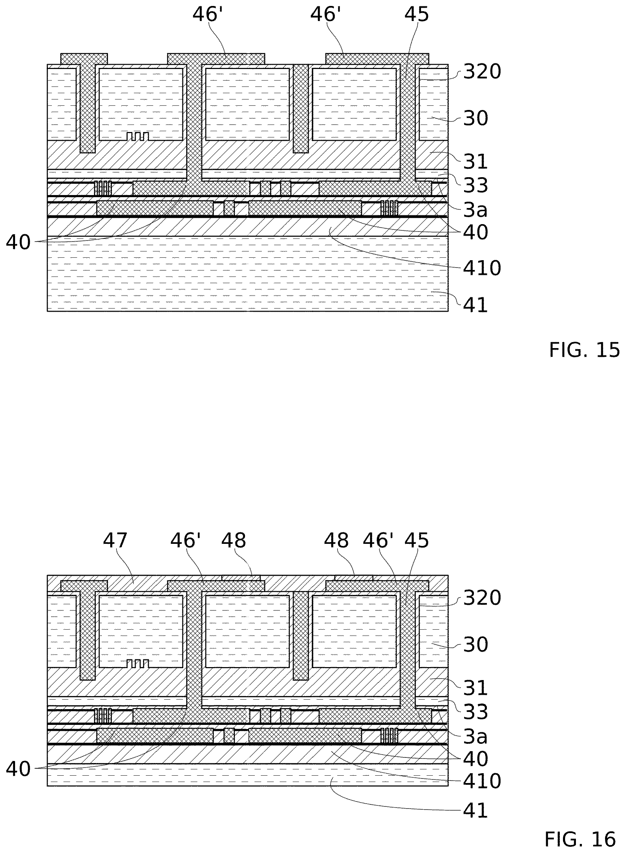

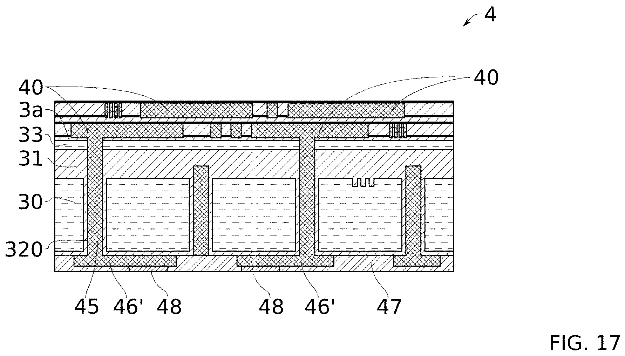

   - les figures 15 à 17 représentent des vues en coupe transversale des étapes suivant le dépôt de l'organe conducteur ou semi-conducteur, selon un exemple de réalisation.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions relatives des sous-substrats et substrat, des couches, des vias et des parois ne sont pas représentatives de la réalité.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement.

Selon un exemple, la deuxième couche est une couche à base, et de préférence faite, d'un matériau choisi parmi un matériau diélectrique, par exemple un oxyde, un matériau semi-conducteur ou un matériau piézoélectrique.

Selon un exemple, la deuxième couche est une couche de matériau diélectrique, par exemple un oxyde, enterrée surmontée par une troisième couche à base d'un matériau choisi parmi un matériau semi-conducteur ou un matériau piézoélectrique. Le substrat peut être de type « Semiconducteur-sur-Isolant », et par exemple de type « Silicium-sur-Isolant ».

Selon un exemple, toutes les dimensions transversales de chaque via sont sensiblement inférieures ou égales à 30 µm.

Selon un exemple, chaque via présente au moins une dimension transversale, par exemple un diamètre, sensiblement comprise entre 1 µm et 30 µm. Selon un exemple, toutes les dimensions transversales de chaque via sont comprises entre 1 µm et 30 µm.

Selon un exemple, au moins une partie des vias présente un facteur de forme supérieur ou égal à 10, de dimensions la plus longue orientée suivant une dimension en épaisseur des première et deuxième couches. Ce facteur de forme est particulièrement adapté pour obtenir une grande densité de via sur le substrat, et notamment en synergie avec les gammes de valeurs de pas énoncées plus haut.

Selon un exemple, la pluralité de vias comprend au moins trois vias, de préférence au moins cinq vias.

Selon un exemple, la pluralité de vias forme une matrice périodique. Ainsi, le substrat comporte une matrice de vias creux qu'il est possible de sélectionner afin de réaliser les interconnexions désirées. Le substrat générique comprenant ces vias permet donc de faciliter la fabrication des vias et de l'organe conducteur ou semi-conducteur, en pouvant notamment s'adapter à différents dispositifs microélectroniques.

Selon un exemple, les vias sont séparés deux à deux par un pas constant suivant au moins une direction du plan d'extension principale des première et deuxième couches.

Selon un exemple, le pas est sensiblement compris entre 50 µm et 300 µm, de préférence entre 100 µm et 200 µm. Ce pas permet une meilleure densité des vias creux dans le substrat. Ainsi, une plus grande densité d'interconnexion est possible. En outre, l'adaptabilité du substrat à différents dispositif microélectronique est améliorée.

Selon un exemple, les vias sont parallèles entre eux.

Selon un exemple, les vias présentent une dimension longitudinale orientée suivant une dimension en épaisseur de la première et de la deuxième couche.

Selon un exemple, les vias s'étendent selon une direction parallèle à la normale au plan d'extension principale des première et deuxième couches.

Selon un exemple, les vias sont cylindriques. Ainsi, la paroi de fond des vias est plus homogène que pour des formes non-cylindriques, par exemple une forme carrée pour laquelle les coins seront moins profond que le centre, suite à la gravure des vias. Une forme cylindrique minimise cet effet. En outre, les contraintes mécaniques sont moins élevées pour des vias cylindriques qui n'ont pas les singularités des coins. C'est avantageux pour les traitements thermiques pendant la fabrication des circuits.

Selon un exemple, la deuxième couche surmonte la première couche en étant directement à son contact.

Selon un exemple, et comme il ressort clairement des figures accompagnant la demande, au moins une partie des vias, et de préférence chaque via, présente une section transversale, par exemple dans un plan sensiblement parallèle au plan d'extension principale des première et deuxième couches, dont le rapport de la dimension la plus grande sur la dimension la plus petite est inférieur ou égal à 3, de préférence inférieur ou égal à 2. Les vias se distinguent donc tout à fait d'autres structures telles que des tranchées.

Selon exemple, au moins un via, et de préférence chaque via, sur au moins une portion d'une dimension longitudinale dudit via, est intégralement entouré par une rainure s'étendant depuis la deuxième couche sur une portion de la première couche. La rainure permet d'améliorer l'isolation électrique entre les vias. La rainure est ainsi fabriquée au préalable et de façon indépendante des autres étapes de fabrication du dispositif microélectronique. La rainure est ainsi compatible avec les étapes de FEOL se déroulant à haute température. En outre, la rainure étant fabriqué au préalable, sa géométrie n'est pas limitée par les autres étapes de fabrication du dispositif microélectronique.

Selon un exemple, chaque rainure n'est pas remplie par un matériau solide. Chaque rainure est de préférence remplie d'une atmosphère gazeuse isolante électriquement, par exemple de l'air, de l'azote ou de l'argon, éventuellement à une pression inférieure ou égale à la pression ambiante.

Selon un exemple, chaque rainure est délimitée par une paroi de fond, une paroi latérale et une paroi supérieure opposée à la paroi de fond. Pour au moins une rainure, et de préférence pour chaque rainure, au moins une partie de la paroi latérale et la paroi de fond peuvent être dans le même matériau que celui de la première couche. L'isolation des via est en effet suffisante grâce à l'atmosphère isolante contenue dans la rainure. Alternativement, pour au moins une rainure, et de préférence pour chaque rainure, au moins une partie de la paroi latérale et la paroi de fond peuvent être en matériau diélectrique, par exemple le même matériau diélectrique que les parois du via. Ainsi, l'isolation électrique du via est encore améliorée.

Selon un exemple, la rainure est concentrique audit via. Cela permet notamment de diminuer la capacité parasite entre le vias et le substrat et d'augmenter la tension de claquage.

Selon un exemple, la rainure s'étend depuis la deuxième couche dans la première couche sur une dimension longitudinale inférieure ou égale à la dimension longitudinale du via, de préférence à plus ou moins 5 µm. Ainsi, la rainure entoure le via sur au moins une portion et de préférence sensiblement toute la dimension longitudinale.

Selon un exemple, le substrat comprend en outre un repère configuré de façon à permettre l'alignement du substrat. Cela permet de faciliter encore la fabrication du dispositif microélectronique, en facilitant l'alignement du substrat, et notamment pour la réalisation des étapes de photolithographies nécessaire à la construction du FEOL et du BEOL, et donc l'ouverture des vias.

Selon un exemple, le matériau semi-conducteur est choisi parmi le groupe constitué de silicium Si, germanium Ge, SiGe, un matériau III-V (par exemple GaN, InN, InGaAs, GaP, InP, InAs, AsGa...), un matériau II-VI, des matériaux à large bande-interdite, par exemple supérieure à 3 eV.

Selon un exemple, le matériau semi-conducteur comprend, et de préférence est, du silicium.

Selon un exemple, le matériau piézoélectrique est choisi parmi le tantalate de lithium (LiTaO₃), le niobate de lithium (LiNbO₃), le niobate de potassium-sodium (KₓNa₁₋ₓNbO₃ ou KNN), le titanate de baryum (BaTiO₃), le quartz, le titano-zirconate de plomb (PZT), un composé de niobate de plomb-magnésium et de titanate de plomb (PMN-PT), l'oxide de zinc (ZnO), le nitrure d'aluminium (AIN) ou le nitrure d'aluminium et de scandium (AlScN).

Selon un exemple, le matériau diélectrique est un oxyde de semi-conducteur, et de préférence de la silice de formule chimique SiO₂.

Selon un exemple, suite à la gravure de la pluralité de vias et de préférence avant l'assemblage du sous-substrat support et du sous-substrat donneur, le procédé comprend, pour chaque via, une formation d'un matériau diélectrique au niveau au moins de la paroi de fond et de la paroi latérale. Ainsi, les vias creux formés dans le substrat présentent une couche diélectrique au moins sur leur paroi de fond et paroi latérale, préalablement à l'utilisation du substrat dans un procédé de fabrication d'un dispositif microélectronique.

Selon un exemple, la formation d'un matériau diélectrique au niveau au moins de la paroi de fond et de la paroi latérale de la pluralité de vias comprend
- une oxydation thermique de façon à oxyder le matériau semi-conducteur de la première couche au niveau au moins de la paroi de fond et de la paroi latérale, et/ou
- un dépôt du matériau diélectrique au niveau au moins de la paroi de fond et de la paroi latérale.

Ces techniques, et tout particulièrement l'oxydation thermique, permettent d'obtenir une bonne conformité des parois en matériau diélectrique. L'oxydation thermique étant conforme, elle permet d'obtenir un oxyde à la fois dense et d'épaisseur uniforme sur les parois de fond et latérales. L'oxydation thermique est donc particulièrement avantageuse en synergie avec des hauts facteurs de forme des vias. Par rapport à un dépôt, l'oxydation thermique permet en outre un lissage de la paroi des vias gravée et limite la présence de défauts entre le matériau semi-conducteur de la première couche et le diélectrique.

Selon un exemple, lorsque au moins la paroi de fond et la paroi latérale sont en matériau diélectrique, la paroi de fond de la pluralité de vias présente une dimension longitudinale sensiblement comprise entre 50 nm et 600 nm, de préférence sensiblement égale à 400 nm.

Selon un exemple, lorsque au moins la paroi de fond et la paroi latérale sont en matériau diélectrique, la paroi latérale de la pluralité de vias présente une dimension transverse sensiblement comprise entre 50 nm et 600 nm, de préférence sensiblement égale à 400 nm.

Selon un exemple, la couche superficielle du sous-substrat donneur est une couche à base, et de préférence faite, d'un matériau choisi parmi un matériau diélectrique, par exemple un oxyde, un matériau semi-conducteur ou un matériau piézoélectrique.

Selon un exemple,
- le sous-substrat support comprend en outre une couche superficielle à base, et de préférence faite, d'un matériau diélectrique, par exemple un oxyde, surmontant la première couche (10), la couche superficielle présentant la surface exposée, et/ou
- la couche superficielle du sous-substrat donneur est une couche à base, et de préférence faite, d'un matériau diélectrique, par exemple un oxyde, surmontant une couche à base d'un matériau choisi parmi un matériau semi-conducteur ou un matériau piézoélectrique.

On comprend donc que la couche d'oxyde enterrée du substrat peut provenir du sous-substrat donneur et/ou du sous-substrat support.

Selon un exemple, la couche superficielle du substrat donneur est à base, de préférence faite, de l'un parmi un matériau semi-conducteur ou un matériau diélectrique. Selon que la couche superficielle est à base d'un matériau semi-conducteur ou d'un matériau diélectrique, on comprend que la paroi supérieure des vias, et le cas échéant des rainures, est à base ou faite d'un matériau semi-conducteur ou d'un matériau diélectrique.

Selon un exemple, la gravure de la pluralité de vias est configurée de façon à former une matrice périodique. Les effets et avantages décrits relativement à la matrice de vias sont donc obtenus.

Selon un exemple, le procédé de fabrication du substrat comprend en outre, préalablement à l'assemblage du sous-substrat support et du sous-substrat donneur, une gravure d'une rainure entourant intégralement au moins un via sur au moins une portion d'une dimension longitudinale dudit via, la rainure s'étendant depuis la couche superficielle dans la première couche. Les effets et avantages décrits relativement à la rainure sont donc obtenus.

Selon un exemple, le procédé comprend une formation d'une zone de fragilisation à une profondeur de la surface de la couche superficielle du substrat donneur, puis une séparation du substrat donneur au niveau de la zone de fragilisation.

Selon un exemple, le procédé de fabrication du dispositif microélectronique comprend préalablement à la gravure par la surface exposée arrière du substrat, une sélection d'au moins un via à graver parmi la pluralité de vias comprenant :
- l'application, sur la surface exposée arrière du substrat, d'un masque comprenant des ouvertures située à l'aplomb de l'au moins un via à graver, et
- une gravure de la première couche de façon à atteindre ladite paroi de l'au moins un via à graver.

Ainsi, il est possible de sélectionner les vias à graver parmi les vias présents. Le procédé est ainsi adaptable selon la configuration de dispositif microélectronique désirée. Cette sélection est particulièrement avantageuse en synergie avec la caractéristique selon laquelle les vias forment une matrice de vias.

Selon un exemple, la sélection de l'au moins un via à graver comprend l'application du masque puis la gravure de la première couche à travers les ouvertures du masque. Ainsi, on évite une potentielle fragilisation de la paroi des vias à graver. Cette gravure grave ainsi la première couche au droit de l'au moins un via à graver jusqu'à déboucher dans l'au moins un via à graver.

Selon un exemple, la sélection de l'au moins un via à graver comprend la gravure de la première couche de façon à atteindre ladite paroi de l'au moins un via à graver, puis l'application du masque. Ainsi, la paroi latérale en matériau diélectrique peut être présente tout le long de la dimension longitudinale de la cavité qui sera formée. Il n'est pas nécessaire d'isoler la portion de la cavité pour compléter la paroi en matériau diélectrique du via. La première couche est plus particulièrement gravée sur l'ensemble de son plan d'extension principale.

Selon un exemple, le dépôt de l'organe électriquement conducteur ou semi-conducteur est configuré de façon à en outre recouvrir par une couche électriquement conductrice ou semi-conductrice au moins une portion de la surface exposée arrière du substrat.

Selon un exemple, le procédé comprend une réalisation de motifs dans la couche électriquement conductrice ou semi-conductrice arrière.

Selon un exemple, le procédé comprend la passivation de la surface exposée arrière du substrat.

Selon un exemple, le procédé de fabrication d'un dispositif microélectronique comprend :
- entre la formation de l'au moins une portion de couche du dispositif, et la gravure par la surface exposée arrière du substrat, le montage d'un support sur la surface exposée avant du substrat, et
- après le dépôt de l'organe électriquement conducteur ou semi-conducteur de façon à remplir la cavité électrique, le démontage du support.

Le support permet ainsi de faciliter la manipulation du substrat.

Par dispositif microélectronique, on entend tout type de dispositif réalisé avec les moyens de la microélectronique. Ces dispositifs englobent notamment en plus des dispositifs à finalité purement électronique, des dispositifs micromécaniques ou électromécaniques, ainsi que des dispositifs optiques ou optoélectroniques. Il peut s'agir d'un dispositif destiné à assurer une fonction électronique, optique, mécanique etc. Il peut aussi s'agir d'un produit intermédiaire uniquement destiné à la réalisation d'un autre dispositif microélectronique. Il peut aussi s'agir d'une structure d'interconnexions électriques passives.

Il est précisé que, dans le cadre de la présente invention, le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément.

Une couche peut par ailleurs être composée de plusieurs sous-couches d'un même matériau ou de matériaux différents.

On entend par un élément « à base » d'un matériau A, un élément comprenant ce matériau A uniquement ou ce matériau A et éventuellement d'autres matériaux.

Dans la description détaillée qui suit, il pourra être fait usage de termes tels que « longitudinal », « transversal ». Ces termes doivent être interprétés relativement au substrat ou à la dimension en épaisseur des dispositifs. Ainsi, une dimension longitudinale, une hauteur, une profondeur ou une épaisseur d'un élément ou d'une couche s'entend d'une dimension selon l'épaisseur du substrat qui le porte ou le contient. Une largeur, ou encore une section ou une dimension transversale s'entend d'une dimension perpendiculaire à l'épaisseur du substrat.

Certaines parties du substrat ou du dispositif de l'invention peuvent avoir une fonction électrique. Certaines sont employées pour des propriétés de conduction électrique et on entend par électriquement conducteurs ou équivalents, des éléments formés d'au moins un matériau ayant une conductivité suffisante, dans l'application, pour réaliser la fonction souhaitée. D'autres parties, au contraire, sont employées pour des propriétés d'isolation électrique et tous matériaux ayant une résistivité suffisante pour réaliser cette isolation sont concernés et sont notamment appelés diélectriques ou électriquement isolants.

Le mot « diélectrique » qualifie plus particulièrement un matériau dont la conductivité électrique est suffisamment faible dans l'application donnée pour servir d'isolant. Dans la présente invention, un matériau diélectrique présente de préférence une constante diélectrique inférieure à 4.

On entend par « collage direct » un collage sans apport de matière adhésive (de type colle ou polymère notamment) qui consiste en la mise en contact de surfaces relativement lisses (d'une rugosité moyenne quadratique RMS, de l'anglais *Root Mean Square,* typiquement inférieure à 5 Å, 10⁻¹⁰ m), par exemple réalisé à température ambiante et sous atmosphère ambiante, afin de créer une adhérence entre elles.

Selon un mode de réalisation, le collage direct de deux substrats signifie que le collage est obtenu par les liens chimiques qui s'établissent entre les deux surfaces mises en contact. Ces liens chimiques peuvent être par exemple des liaisons de Van der Waals et/ou des liaisons chimiques fortes, covalentes, notamment lorsque le collage est assisté par une activation plasma ou suivi d'un traitement thermique de renforcement (typiquement 200 à 1200°C pendant 1h).

Le collage direct peut être obtenu sans nécessiter l'application d'une pression importante sur la structure à assembler. Une légère pression pourra simplement être appliquée pour initier le collage. Un recuit thermique peut en outre être effectué pour renforcer le collage.

On entend par un paramètre « sensiblement égal/supérieur/inférieur à » une valeur donnée, que ce paramètre est égal/supérieur/inférieur à la valeur donnée, à plus ou moins 10% près, voire à plus ou moins 5% près, de cette valeur.

Le substrat 3 est maintenant décrit selon plusieurs exemples de réalisation en référence aux figures 2A à 3C.

Comme par exemple illustré par la figure 2A, le substrat 3 comprend une première couche 30, à base ou faite d'un matériau semi-conducteur. Selon un exemple le matériau semi-conducteur comprend, et de préférence est, du silicium. La première couche 30 présente une épaisseur L₃₀, par exemple sensiblement comprise entre 100 µm et 800 µm.

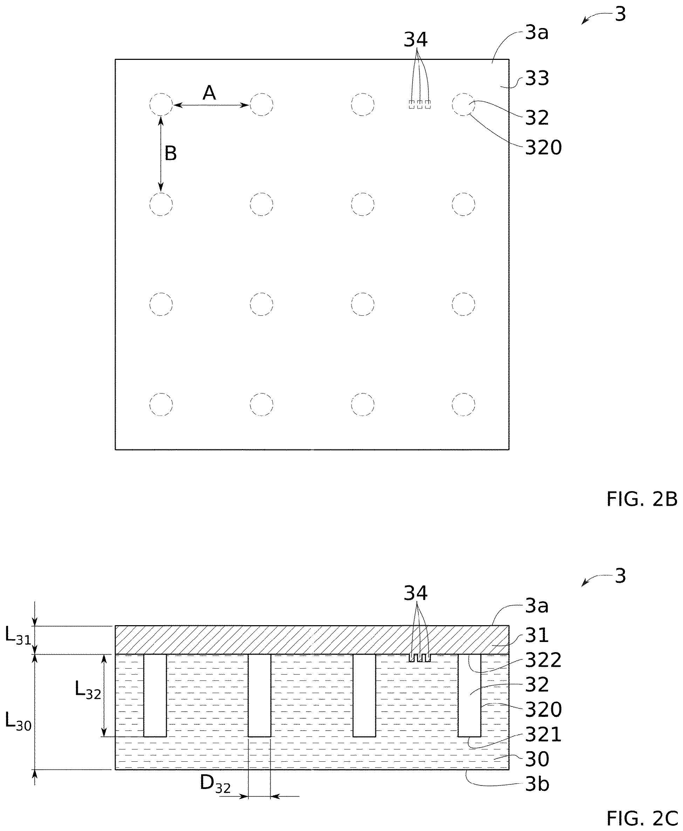

Le substrat 3 comprend en outre une deuxième couche 31. Comme illustré par la figure 2A, la deuxième couche 31 peut être à base ou faite d'un matériau diélectrique. Selon un exemple le matériau semi-conducteur comprend, et de préférence est, un oxyde de semi-conducteur, par exemple de la silice de formule SiO₂. La deuxième couche 31 surmonte la première couche 30, de préférence en étant directement à son contact. Comme illustré par la figure 2C, la deuxième couche 31 peut être à base ou faite d'un matériau semi-conducteur, de préférence monocristallin, ou d'un matériau piézoélectrique. La deuxième couche 31 peut présenter une épaisseur L₃₁, par exemple supérieure ou égale à 10 nm, préférentiellement à 100 nm. L'épaisseur L₃₁ peut être inférieure ou égale à 1000 nm. La deuxième couche 31 du substrat 3 est de préférence exempte de portions métalliques. La deuxième couche 31 est de préférence continue dans le plan d'extension principale du substrat 3.

Selon un exemple, par exemple illustré par la figure 2A la deuxième couche 31 est surmontée d'une troisième couche 33 à base ou faite d'un matériau semi-conducteur, de préférence monocristallin, ou d'un matériau piézoélectrique. Selon un exemple le matériau semi-conducteur comprend, et de préférence est, du silicium. La troisième couche 33 présente une épaisseur L₃₃, par exemple sensiblement comprise entre 10 nm et 1000 nm. Le substrat 3 comprend ainsi une structure de type semi-conducteur sur isolant, et notamment de type silicium-sur-isolant (SOI). Notons qu'on peut prévoir que la deuxième couche 31 ne soit pas surmontée d'une troisième couche semi-conductrice. La troisième couche 33 du substrat 3 est de préférence exempte de portions métalliques. La troisième couche 33 est de préférence continue dans le plan d'extension principale du substrat 3.

Selon un exemple, le matériau à base duquel une couche 30, 31, 33 est formée est de préférence continu dans le plan d'extension de la couche. Au moins une et de préférence chaque couche(s) 30, 31 33 est de préférence continue sur au moins 80 %, de préférence sur au moins 90 %, et plus préférentiellement encore la totalité, du plan d'extension principale du substrat 3.

La première couche 30 et/ou la deuxième couche 31 est/sont de préférence monolithique(s). La première couche 30 est de préférence monolithique sur au moins la portion sur laquelle s'étendent les vias 32.

Dans la suite, sauf mention explicite du contraire, on considère à titre non-limitatif que le substrat 3 est un substrat SOI, la première couche 30 étant en silicium monocristallin, la deuxième couche en SiO₂ et la troisième couche en silicium monocristallin.

Le substrat 3 comprend des vias 32 creux s'étendant depuis la deuxième couche 31 dans la première couche 30. De façon connue pour l'homme du métier, un via est un trou d'interconnexion dans un substrat. Les vias se distinguent donc tout à fait d'autres structures telles que des tranchées. Les vias 32 peuvent être parallèles entre eux. Les vias 32 s'étendent de préférence sur une dimension longitudinale L₃₂ orientée dans le sens de l'épaisseur des première 30 et deuxième 31 couches. Les vias 32 sont enterrés dans le substrat 3, c'est-à-dire qu'ils ne débouchent pas sur l'une ou l'autre des surfaces exposées 3a, 3b du substrat 3. Les vias 32 définissent donc un volume clos, et plus particulièrement chaque via 32 définit donc un volume clos comme il ressort clairement des figures. Les vias 32 ne communiquent pas entre eux, comme il ressort clairement des figures. Les vias 32 étant creux, ils ne sont pas remplis d'un matériau solide. Ils sont de préférence remplis d'une atmosphère gazeuse telle que de l'air, de l'azote et/ou de l'argon, éventuellement à une pression inférieure ou égale à la pression ambiante.

Ainsi, le substrat 3 comprend des vias creux 32 pour un remplissage ultérieur. Ceci permet de fournir les vias creux indépendamment des autres étapes de réalisation d'un dispositif microélectronique 4, comme décrit ultérieurement en référence au procédé de fabrication d'un dispositif microélectronique.

La dimension longitudinale L₃₂ peut être choisie de façon à s'étendre sur au moins une portion de l'épaisseur L₃₁ de la deuxième couche, et une portion seulement de l'épaisseur L₃₀ de la première couche 30, comme par exemple illustré en figure 2A. En variante, les vias 32 peuvent affleurer la surface de la première couche 30, comme par exemple illustré en figure 2C.

Les vias 32 sont délimités par une paroi latérale 320, une paroi de fond 321 et une paroi supérieure 322 opposée à la paroi de fond 321. La paroi de fond 321 est disposée vers la surface arrière 3b du substrat 3 et la paroi supérieure 322 est disposée vers la surface avant 3a du substrat 3.

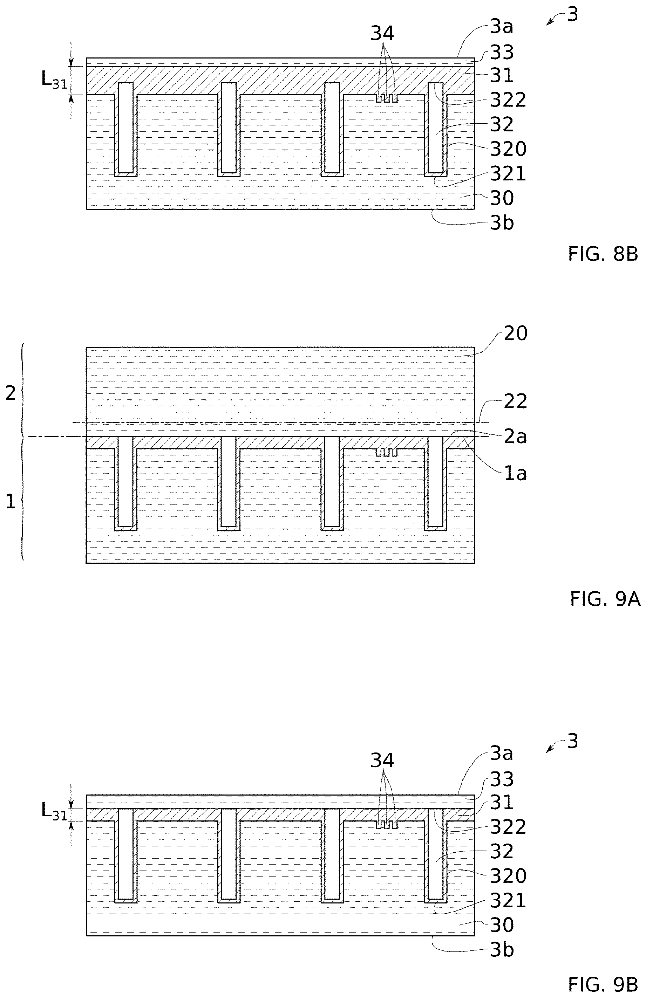

Parmi ces parois, au moins la paroi de fond 321 et la paroi latérale 320 peuvent être en matériau diélectrique, par exemple en SiO₂. Ainsi, le via 32 une fois rempli par un matériau conducteur électriquement ou semi-conducteur sera isolé électriquement de la première couche 30 et des autres vias 32. Comme l'illustre la figure 2A, toutes les parois des vias 32 peuvent être en matériau diélectrique. Selon une variante, la paroi supérieure 322 peut être dans le même matériau que la troisième couche 33, comme par exemple illustré en figure 9A décrite plus en détail ultérieurement en référence au procédé de fabrication du substrat 3.

En variante, comme par exemple illustré par la figure 2C, les parois des vias 32 peuvent être en matériau semi-conducteur, et plus particulièrement du même matériau que celui de la première couche 30. L'isolation électrique des vias 32 peut être faite ultérieurement lors du procédé de fabrication du dispositif microélectronique à partir du substrat 3, décrit ultérieurement.

Les vias peuvent présenter une dimension transversale D₃₂, par exemple un diamètre, sensiblement inférieure ou égale à 30 µm, de préférence sensiblement comprise entre 1 µm et 30 µm, de préférence sensiblement comprise entre 5 µm et 15 µm, et plus préférentiellement encore entre 8 et 12 µm. Ainsi, la dimension latérale D₃₂ est inférieure aux dimensions typiques des TSV-last, ce qui permet d'avoir un plus grand nombre de vias 32 pour une même surface du substrat 3 dans le plan d'extension principale des première 30 et deuxième 31 couches, c'est-à-dire une plus grande densité de vias 32. La dimension longitudinale des vias L₃₂ peut être de l'ordre de l'épaisseur L₃₀ de la couche 30, les vias 32 étant non débouchants. L₃₂ peut être sensiblement inférieure ou égale à 200 µm, de préférence sensiblement comprise entre 50 et 150 µm, par exemple sensiblement égale à 100 µm. Ces gammes de longueur permettent de faciliter la formation d'un organe électriquement conducteur ou semi-conducteur traversant, par exemple une interconnexion traversante par le via 32, du substrat 3 lors de la fabrication du dispositif microélectronique 4.

Les vias 32 peuvent présenter un facteur de forme sensiblement supérieur ou égal à 5, et de préférence supérieur ou égal à 10. Par facteur de forme, on entend le rapport entre la dimension la plus longue sur la dimension la plus courte. Ici le facteur de forme F est tel que F = L₃₂/D₃₂. Ce facteur de forme permet de faciliter la formation d'un organe électriquement conducteur ou semi-conducteur traversant, par exemple une interconnexion traversante par le via 32, lors de la fabrication du dispositif, et d'augmenter la densité des vias 32 sur le substrat, en synergie avec le pas les séparant.

Selon un exemple pouvant être illustré par la figure 2B, les vias 32 forment une matrice périodique, c'est-à-dire que les vias 32 sont disposés à intervalles réguliers dans le plan d'extension principale des première 30 et deuxième 31 couches. Ainsi, le substrat 3 peut être un substrat générique comprenant une matrice de vias, dans laquelle des vias à graver et à remplir 32' seront choisis en fonction des organe électriquement conducteur ou semi-conducteur à former, comme décrit plus en détail ultérieurement.

Pour cela, les vias 32 peuvent être séparés deux à deux par un premier pas A selon une première direction contenue dans le plan d'extension principale des première 30 et deuxième 31 couches. Les vias 32 peuvent être séparés deux à deux par un deuxième pas B selon une deuxième direction contenue dans le plan d'extension principale des première 30 et deuxième 31 couches, distincte de la première. De préférence, ces première et deuxième directions sont perpendiculaires. L'un et/ou l'autre de ces pas A et B peuvent être sensiblement compris entre 50 µm et 300 µm, de préférence entre 100 µm et 200 µm. Ces pas peuvent être différents l'un de l'autre ou égaux entre eux, selon la géométrie de matrice désirée. Ce pas est mesuré centre à centre entre deux vias 32 se suivant directement. Les pas A et/ou B sont de préférence constants, c'est à dire sensiblement identiques pour chaque répétition de motifs.

Selon un exemple préférentiel, le substrat 3 comprend un unique motif de via 32, comprenant de préférence un seul via 32. Selon cet exemple, chaque via 32 est séparé du ou des vias 32 voisins par des pas A et B sensiblement identiques pour chaque répétition de motifs. Les pas A et B sont de préférence égaux entre eux.

Les vias 32 peuvent se répéter le long d'une direction, de préférence des deux directions distinctes ci-dessus, du plan d'extension principale des première 30 et deuxième 31 couches, sur au moins 80 % de la dimension du substrat 3 selon cette/ces direction(s). Les vias 32 se répètent de préférence, dans le plan d'extension principale de la première couche 30, sur au moins 80 %, de préférence au moins 90 %, et plus préférentiellement encore au moins 95 %, du plan d'extension principale de la première couche 30. Les vias 32 se répètent en outre de préférence, dans le plan d'extension principale du substrat 3, sur au moins 80 %, de préférence au moins 90 %, et plus préférentiellement encore au moins 95 %, du plan d'extension principale du substrat 3. Le substrat générique 3 comprend ainsi une matrice de vias 32 génériques sur une grande partie de sa surface, pour faciliter la fabrication d'un dispositif microélectronique comme décrit en détail ultérieurement. Ces vias 32 pourront notamment être sélectionnés en fonction de l'architecture désirée, avec un substrat générique 3 qui puisse être adapté à la fabrication de différents dispositifs microélectroniques.

Selon un exemple, au moins une partie des vias 32 et de préférence chaque via, s'étend sur une hauteur supérieure ou égale à 50 % de l'épaisseur du substrat 3, de préférence supérieure ou égale à 70 % de l'épaisseur du substrat 3.

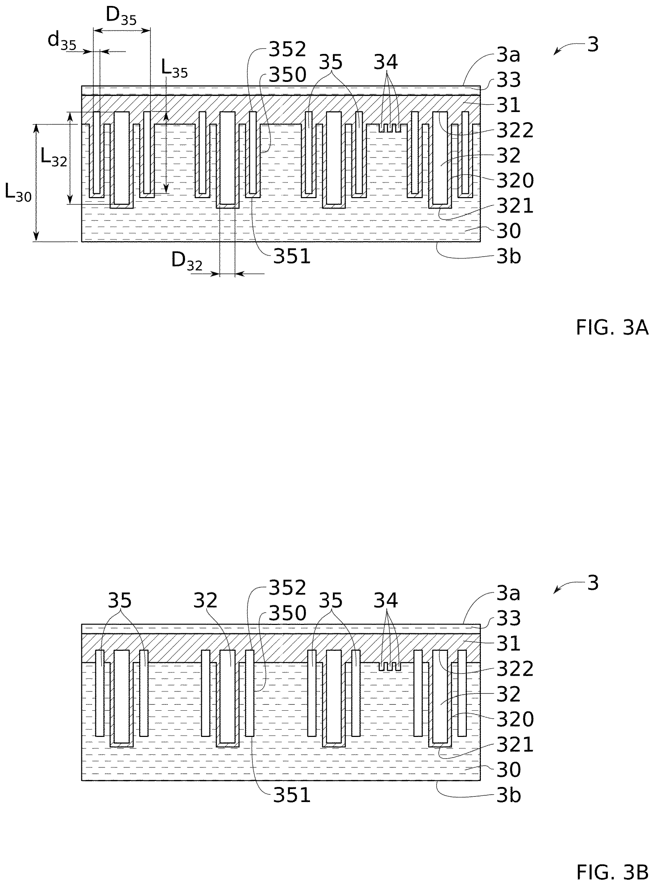

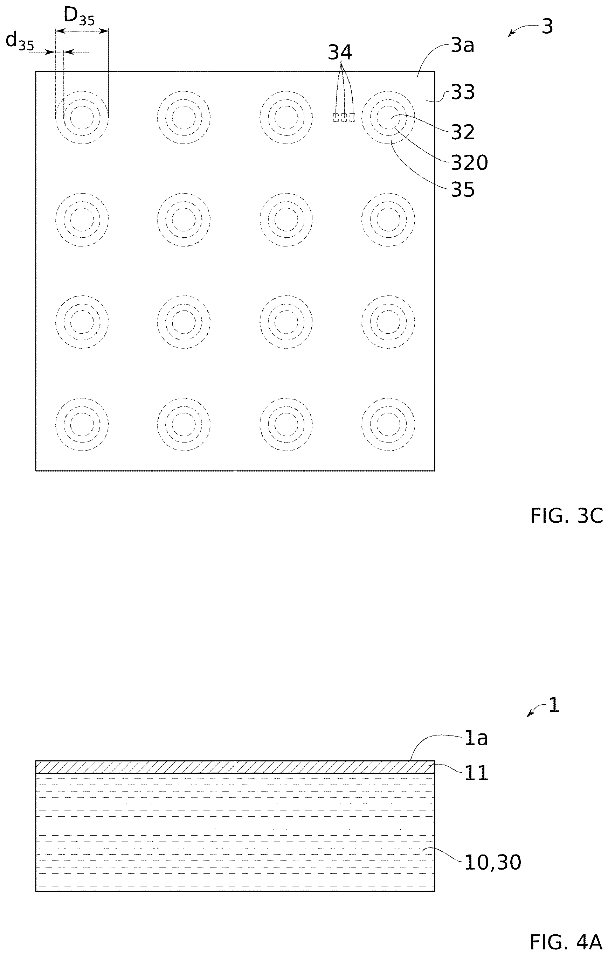

Selon un exemple pouvant être illustré par les figures 3A et 3B, le substrat 3 peut comprendre au moins une et de préférence plusieurs rainure(s) 35 configurée(s) pour améliorer l'isolation électrique des vias 32. Le substrat 32 est ainsi particulièrement adapté pour des applications de hautes fréquences et/ou en remplacement de substrat de haute résistivité pour les applications le demandant. Pour cela, au moins un via 32, et de préférence chaque via 32, présente une section transversale intégralement entourée de la rainure 35, prise dans le plan d'extension principale des première 30 et deuxième 31 couches. La rainure 35 peut entourer le via 32 sur au moins une portion de sa dimension longitudinale L₃₂. Les rainures 35 sont de préférence disposées de façon à isoler les vias 32 les uns des autres, une rainure 35 entourant de préférence un seul via 32. Les rainures 35 ne se touchent de préférence pas entre elles. La rainure 35 peut plus particulièrement s'étendre depuis la deuxième couche 31 sur une portion de la première couche 30.

Chaque rainure 35 est de préférence enterrée, c'est-à-dire qu'elle ne débouche pas sur l'une ou l'autre des surfaces exposées 3a, 3b du substrat 3. Chaque rainure 35 définit donc un volume clos. Chaque rainure 35 est de préférence creuse, elle n'est pas remplie d'un matériau solide. Chaque rainure 35 est de préférence remplie d'une atmosphère gazeuse telle que de l'air, de l'azote ou de l'argon, éventuellement à une pression inférieure ou égale à la pression ambiante.

Chaque rainure 35 est délimitée par une paroi latérale 350, une paroi de fond 351 et une paroi supérieure 352 opposée à la paroi de fond 351. La paroi de fond 351 est disposée vers la surface arrière 3b du substrat et la paroi supérieure 352 est disposée vers la surface avant 3a du substrat 3. Parmi ces parois, au moins la paroi de fond 351 et la paroi latérale 350 peuvent être en matériau diélectrique, par exemple en SiO₂. Comme l'illustre la figure 3A, toutes les parois peuvent être en matériau diélectrique. Selon une variante non représentée sur les dessins, la paroi supérieure 352 peut être dans le même matériau que la deuxième couche 31. On peut également prévoir que la rainure 35 affleure la surface de la première couche 30, comme les vias 32 illustrés en figure 2C. Selon une autre variante pouvant par exemple être illustrée par la figure 3B, toutes les parois peuvent être dans le même matériau que la couche dans laquelle ou contre laquelle elles s'étendent, en matériau diélectrique ou semi-conducteur selon la couche considérée.

Comme illustré par exemple par la figure 3A, chaque rainure 35 peut présenter une dimension longitudinale, ou de façon équivalente une profondeur, L₃₅ sensiblement égale ou inférieure à celle du via L₃₂, selon un exemple égale à plus ou moins 5 µm.

Comme illustré par exemple par les figures 3A et 3B, chaque rainure 35 peut présenter une dimension transversale D₃₅ prise de part et d'autre du via 32, par exemple un diamètre, sensiblement inférieure ou égale à 50 µm, de préférence sensiblement comprise entre 20 µm et 30 µm. Chaque rainure 35 peut présenter une largeur sensiblement inférieure ou égale à 5 µm, par exemple sensiblement comprise entre 2 et 4 µm. Ainsi, de façon similaire aux dimensions des vias 32, une amélioration de l'isolation électrique peut être obtenue tout en permettant d'obtenir une grande densité de vias 32. Synergiquement, il est particulièrement avantageux d'utiliser ces rainures 35 lorsque les vias 32 sont proches les uns des autres, comme c'est le cas pour une haute densité de vias 32 sur le substrat 3, afin d'améliorer leur isolation électrique. Par haute densité, par exemple les pas A et/ou B sont inférieurs ou égaux à 100 µm. On peut prévoir que les rainures 35 présentent des dimensions égales ou distinctes entre les différentes rainures 35.

Selon les dimensions des rainures 35 dans le plan d'extension principale des première 30 et deuxième 31 couches, le pas peut être adapté de sorte que les rainures 35 sont distinctes les unes des autres. Chaque rainure 35 peut être cylindrique, et de préférence concentrique au via 32 qu'elle entoure.

Comme l'illustrent par exemple les figures 2A à 3C, le substrat 3 peut comprendre au moins une marque ou de façon équivalente un repère 34 permettant l'alignement du substrat 3 avec d'autres éléments. Ainsi, le placement des vias 32 lors du procédé de fabrication du dispositif microélectronique est fiabilisé. Ce repère 34 peut être formé par une ou plusieurs portion(s) de couche de matériau diélectrique au niveau de la première couche 30 et/ou deuxième couche 31. Notons que la personne du métier peut tout à fait envisager d'autres variantes de repère, comme par exemple un marquage disposé sur la surface 3a avant du substrat 3.

Le procédé de fabrication du substrat 3 est maintenant décrit en référence aux figures 4A à 9B.

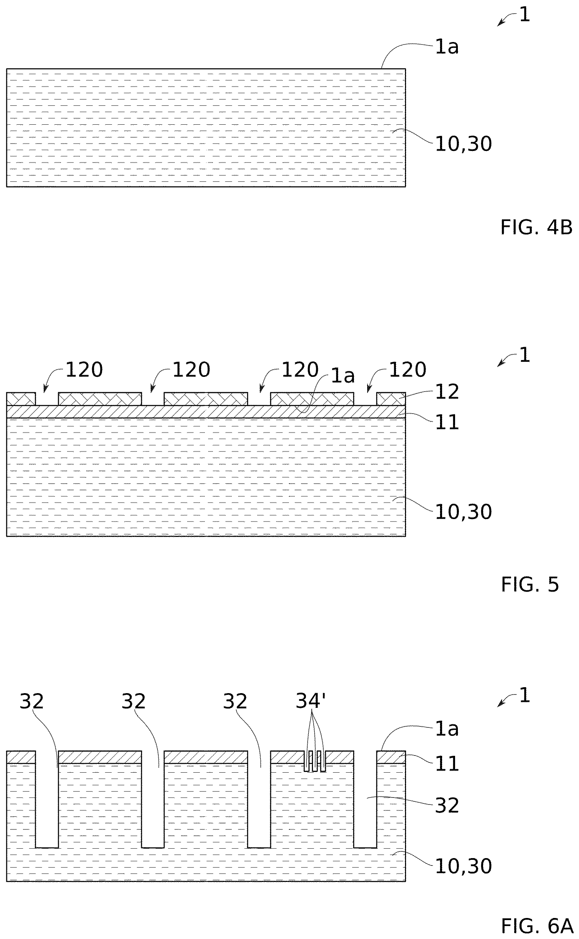

Le procédé comprend la fourniture d'un sous-substrat 1. Le sous-substrat 1 comprend au moins une première couche 10, destinée à former la première couche 30 du substrat 3 qui sera obtenu, comme l'illustrent les figures 4A et 4B. Le sous-substrat 1 peut comprendre en outre, comme par exemple illustré par la figure 4A, une couche superficielle 11 destinée à former au moins en partie la deuxième couche 31 du substrat 3. La couche superficielle 11 est de préférence à base ou faite d'un matériau diélectrique. Le sous-substrat 1 présente en outre une surface exposée 1a, au niveau de la première couche 10 ou de la couche superficielle 11.

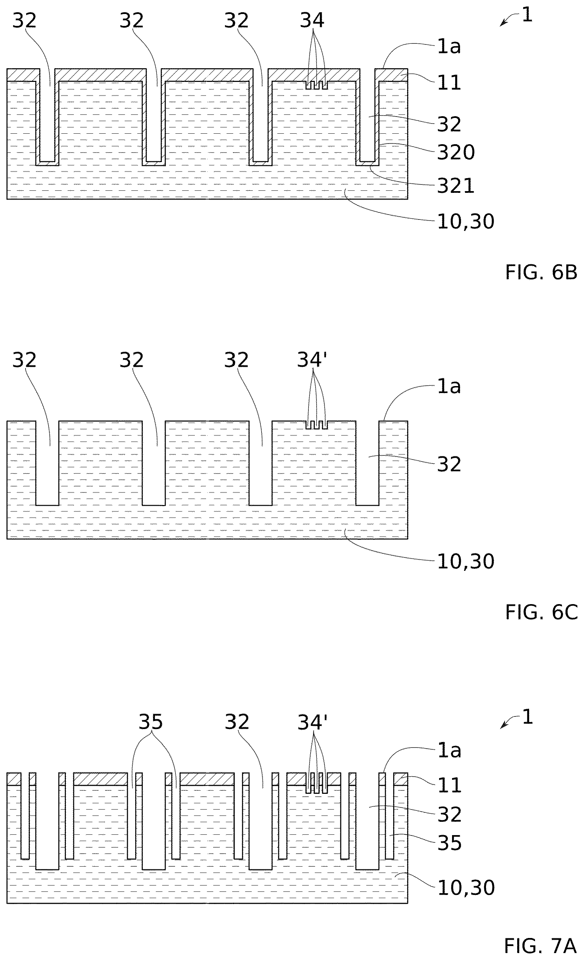

Comme par exemple illustré par les figures 5 et 6A, 6C, les vias 32 peuvent être formés par gravure, et de préférence par gravure ionique réactive profonde (communément abrégée DRIE, de l'anglais « *Deep Reactive Ion Etching* »). Pour former les vias 32, l'étape de gravure peut comprendre l'application d'un masque 12 comprenant des ouvertures 120 à partir desquelles les vias 32 vont être gravés, comme l'illustre par exemple la figure 5. Le masque 12 est de préférence un masque en résine. On peut prévoir que le masque soit dur, par exemple avec l'application d'un masque 12 en résine puis la gravure de la couche superficielle 11, retirer ce masque et graver la première couche 10 grâce au masque d'oxyde dit « dur » ainsi formé. Notons que la couche superficielle 11 peut être retirée après la gravure des vias 32, et les vias 32 isolés électriquement par dépôt d'une couche diélectrique par la suite.

La gravure est de préférence configurée pour obtenir les caractéristiques des vias 32 décrites précédemment, et notamment leurs dimensions et les pas les séparant. Par exemple, les dimensions du masque 12 et/ou le temps et la vitesse de gravure sont ajustés pour cela.

Pour former les vias 32, le procédé peut ensuite comprendre une formation d'un matériau diélectrique au niveau au moins de la paroi de fond 321 et de la paroi latérale 320, comme l'illustre par exemple la figure 6B.

Cette formation peut être faite par oxydation thermique, par exemple à une température de sensiblement 1050 °C dans une atmosphère comprenant de l'oxygène.

En variante ou en complément, le matériau diélectrique, par exemple de la silice SiO₂, peut être déposé au niveau au moins des parois 320, 321 des vias 32. Ce dépôt peut être un dépôt chimique en phase vapeur (communément abrégé CVD, de l'anglais *Chemical Vapor Deposition*) à partir de précurseurs gazeux comprenant de l'oxygène et du silicium, par exemple de l'orthosilicate de tétraéthyle (communément abrégé TEOS de l'anglais *tetraethyl orthosilicate*) ou du silane de formule chimique SiH₄, éventuellement combiné avec du dioxygène. Le dépôt est par exemple un dépôt CVD à pression subatmosphérique (communément abrégé SACVD, de l'anglais *Sub-Atmospheric CVD*), ou un dépôt en phase chimique assisté par plasma (communément abrégé PECVD, de l'anglais Plasma-Enhanced CVD.

De préférence, le masque 12 est retiré préalablement à la formation de ces parois en matériau diélectrique. Dans le cas où la couche 11 a servi de masque dur il est préférable de la retirer également.

De préférence, la formation des parois 320, 321 est configurée de sorte que les parois 320, 321 en matériau diélectrique présentent une dimension sensiblement comprise entre 50 nm et 600 nm, et de préférence sensiblement égale à 400 nm. Pour la paroi latérale 320, cette dimension est la dimension transversale. Pour la paroi de fond 321, cette dimension est la dimension longitudinale. Par exemple, le temps d'oxydation thermique ou le temps de dépôt et/ou la vitesse de dépôt peuvent être ajustés pour cela.

Le procédé peut comprendre, simultanément ou concomitamment à la gravure des vias 32 et le cas échéant à la formation des parois en matériau diélectrique, une étape de formation du repère 34. Pour cela, le masque peut en outre comprendre des ouvertures, non représentées ici, pour graver par exemple des ouvertures 34' dans la deuxième couche 31 jusqu'à dans la première couche 30, illustrées par exemple en figure 6A. Les ouvertures 34' peuvent être remplies du matériau diélectrique lors de la formation des parois. La formation du repère 34 peut être distincte de ces étapes, par l'application par exemple d'un masque spécifique à ce repère 34, gravure et remplissage des ouvertures 34'. Si la formation du repère 34 est distincte de ces étapes, elle serait avantageusement réalisée avant, pour servir de repère au positionnement des vias 32.

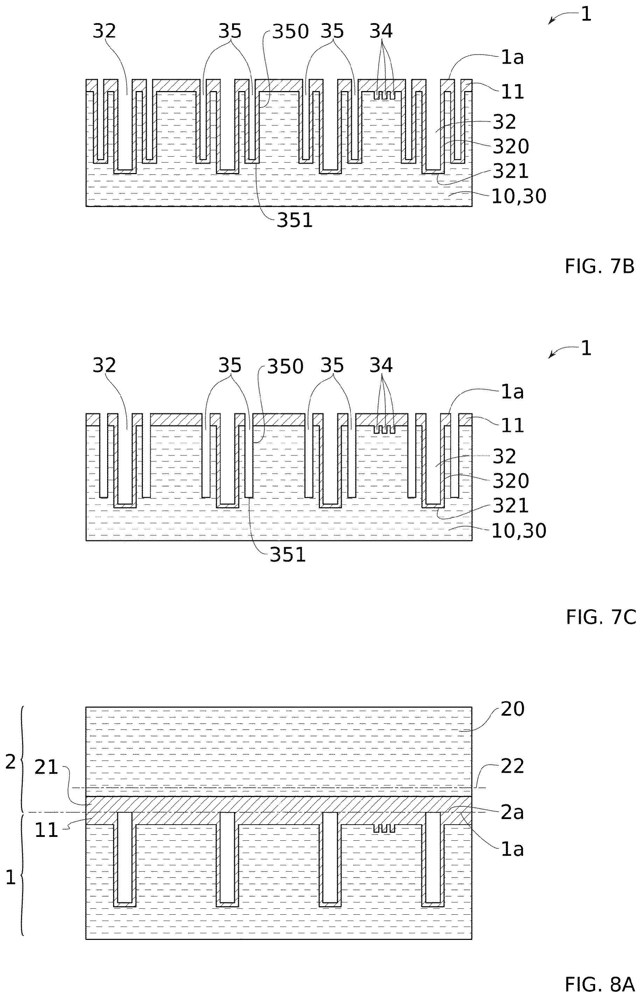

Les figures 7A à 7C illustrent des exemples dans lesquels des rainures 35 sont formées autour des vias 32. Une seule rainure est représentée pour simplifier les figures. La formation des rainures 35 peut comprendre les mêmes étapes que pour la gravure des vias 32 et le cas échéant pour la formation des parois en matériau diélectrique. Les rainures 35 peuvent être formées simultanément aux vias 32, le masque 12 comprenant alors des ouvertures correspondant aux rainures 35 à graver. Les rainures 35 peuvent en alternative être gravées avant ou après la gravure des vias 32, par exemple par application d'un masque et une gravure spécifiques aux rainures 35. Selon un exemple, une fois les rainures 35 et vias 32 gravés, un matériau diélectrique peut être formé au niveau des parois 350, 351, 320, 321 comme précédemment décrit. En alternative, les rainures 35 peuvent être formées après la formation du matériau diélectrique au niveau des parois 320 et 321. On peut prévoir qu'une nouvelle formation de matériau diélectrique soit faite au niveau des parois 350, 351, selon les modalités précédemment décrites. La gravure des rainures 35 peut autrement ne pas être suivie d'une formation de matériau diélectrique au niveau des parois 350 et 351, comme l'illustre par exemple la figure 7C. Les rainures 35 et les vias 32 peuvent ne pas présenter de paroi en matériau diélectrique, selon une variante non illustrée.

Suite à la formation des vias 32 et le cas échéant des rainures 35, ces structures peuvent être recouvertes pour être enterrées lors de l'assemblage du sous-substrat 1 avec un sous-substrat donneur 2. Le procédé peut donc comprendre la fourniture d'un sous-substrat donneur 2 présentant une surface exposée 2a.

Comme illustré par les figures 8A à 9C, les sous-substrats support 1 et donneur 2 peuvent être assemblés par la mise en contact par collage direct de leurs surfaces respectives 1a, 2a. Le substrat donneur 2 peut ensuite être aminci, par exemple par clivage par le procédé connu sous le nom de Smart-Cut^{®}.

L'assemblage peut pour cela comprendre, avant la mise en contact des surfaces 1a, 2a, la formation d'une zone de fragilisation 22 à une profondeur non nulle de la surface 2a du sous-substrat donneur 2. Cette zone de fragilisation 22 est par exemple formée par implantation d'ions, tels que des ions d'hydrogène et/ou d'hélium. Notons que toute autre technique de formation d'une zone de fragilisation, et notamment tout autre technique employée dans les procédés d'élaboration d'empilement de type SOI, peut être envisagée.

Suite à l'assemblage du sous-substrat support 1 et du sous-substrat donneur 2, le procédé peut comprendre la séparation d'une couche superficielle du sous-substrat donneur 2, au niveau de la zone de fragilisation 22, comme sur les exemples illustrés en figures 8B et 9B. Cette séparation peut être faite thermiquement ou mécaniquement, selon des étapes connues de la personne du métier.

Suite à la séparation, la surface 3a obtenue peut être irrégulière et endommagée. Un polissage, lissage chimique, guérison chimique et/ou mécanique et/ou thermique et/ou par faisceau ionique à base d'amas d'atomes ou à base de monomères de la surface 3a peut être réalisé, de sorte que la surface 3a présente une qualité cristalline et une rugosité adaptée pour d'autres procédés ultérieurs. Toute méthode de polissage mécano-chimique (CMP, abrégé de l'anglais *Chemical Mechanical Polishing*) ou thermique destinée à lisser une surface à base de semi-conducteur et notamment de silicium peut être envisagée.

Selon un exemple, le sous-substrat donneur 2 comprend une couche 20 à base ou faite d'un matériau semi-conducteur, par exemple en silicium et plus particulièrement en silicium monocristallin. Le sous-substrat donneur 2 peut comprendre en outre une couche 21 à base ou faite d'un matériau diélectrique, par exemple en silice SiO₂.

Selon un exemple pouvant être illustré par les figures 8A et 8B, la couche 21 peut former la couche superficielle du sous-substrat donneur 2. On peut notamment réaliser un collage direct oxyde de semi-conducteur, par exemple oxyde de silicium, contre oxyde de semi-conducteur, par exemple oxyde de silicium. Suite à leur assemblage, la couche 21 et la couche 11 vont former la deuxième couche 31 du substrat 3. Leurs épaisseurs respectives peuvent donc être choisies pour obtenir l'épaisseur L31 voulue. Selon cet exemple, on comprend que la paroi supérieure 322 des vias 32 et le cas échéant la paroi supérieure 352 des rainures 35 peut être formée d'un matériau diélectrique. La paroi supérieure 322 des vias 32 et le cas échéant la paroi supérieure 352 des rainures 35 peut par exemple présenter une épaisseur sensiblement comprise entre 1 nm et 600 nm.

Selon un exemple pouvant être illustré par les figures 9A et 9B, la couche 20 peut former la couche superficielle du sous-substrat donneur 2. On peut réaliser un collage direct oxyde de semi-conducteur, par exemple oxyde de silicium, contre semi-conducteur, et notamment silicium. Suite à leur assemblage, la couche 11 seule va former la deuxième couche 31 du substrat 3. Son épaisseur peut donc être choisie pour obtenir l'épaisseur L₃₁ voulue. Selon cet exemple, on comprend que la paroi supérieure 322 des vias 32 et le cas échéant la paroi supérieure 352 des rainures 35 peut être formée d'un matériau semi-conducteur.

Selon un exemple pouvant être illustré par la figure 9C, la couche 20 peut former la couche superficielle du sous-substrat donneur 2. On peut réaliser un collage direct de semi-conducteur ou piézoélectrique contre semi-conducteur, et notamment silicium, lorsque la couche 20 est à base d'un matériau semi-conducteur ou piézoélectrique. On peut réaliser un collage direct d'oxyde de semi-conducteur contre semi-conducteur, et notamment silicium, lorsque la couche 20 est à base d'un matériau diélectrique, et notamment d'un oxyde. Suite à leur assemblage, la couche 20 va former la deuxième couche 31 du substrat 3. Son épaisseur peut donc être choisie pour obtenir l'épaisseur L₃₁ voulue.

Notons qu'il est préférable d'avoir pour l'assemblage une épaisseur de matériau diélectrique, et notamment d'oxyde, d'au moins 10 nm à l'interface de collage pour éviter l'apparition de défauts.

Le procédé de fabrication d'un dispositif microélectronique 4 est maintenant décrit en référence aux figures 10 à 17.

Dans ce procédé, les vias 32 peuvent servir à établir des interconnexions. Les vias 32 peuvent en alternative ou en complément servir à former des portions d'un dispositif microélectronique sans nécessairement être des interconnexions métalliques, par exemple dans un dispositif MEMS. Les vias peuvent être destinés à être remplis d'un matériau semi-conducteur, du Poly-Si par exemple.

Le procédé peut comprendre une fourniture du substrat 3. Le procédé peut comprendre le dépôt de couches de composants 4' (illustré en figure 1), par exemple de transistor, de diode, de point mémoire. Ce dépôt peut par exemple comprendre les étapes du FEOL.

Comme par exemple illustré sur la figure 10, le procédé peut comprendre le dépôt d'au moins une portion de couche 40, aussi appelé portion 40 de dispositif, sur la surface avant 3a du substrat 3. Dans la suite, on considère à titre non limitatif que plusieurs portions 40 sont déposées. En alternative ou en complément, la ou les portion(s) de dispositif peut/peuvent être gravée(s) dans la surface exposée avant 3a du substrat 3.

Ces portions 40 peuvent être métalliques et peuvent notamment former des lignes d'interconnexions métalliques. Typiquement ces portions métalliques 40 peuvent servir à redistribuer des signaux électriques. Ces portions métalliques peuvent aussi être désignées niveaux de métallisation. Il peut y avoir plusieurs portions métalliques 40 avec des interconnexions entre ces portions. Ce dépôt peut par exemple comprendre les étapes du BEOL.

Dans la suite, on considère à titre non-limitatif que ces portions 40 sont métalliques et que le via gravé 32 sert à établir une interconnexion. Les étapes suivantes s'appliquent tout à fait au cas où des portions 40 de dispositif 4 non métalliques sont déposées et/ou gravées, et/ou où un organe semi-conducteur 45 est réalisé dans le via 32.

Afin de faciliter la manipulation du substrat 3, le procédé peut ensuite comprendre le montage d'un support 41 du côté de la surface avant 3a exposée du substrat 3, par exemple par le biais d'un collage 410 réalisés sur les dépôts précédents, comme illustré par la figure 11 par exemple. Cela permet en outre de protéger les dépôts réalisés en surface avant 3a du substrat 3.

Après le dépôt des portions métalliques 40, le cas échéant après le montage du support 41, le procédé comprend la gravure d'au moins un via 32 afin de réaliser au moins une interconnexion avec une des portions métalliques 40. Pour cela, plusieurs exemples sont possibles et sont maintenant décrit. Dans la suite, on considère à titre non limitatif que l'on grave et on remplit plusieurs vias 32.

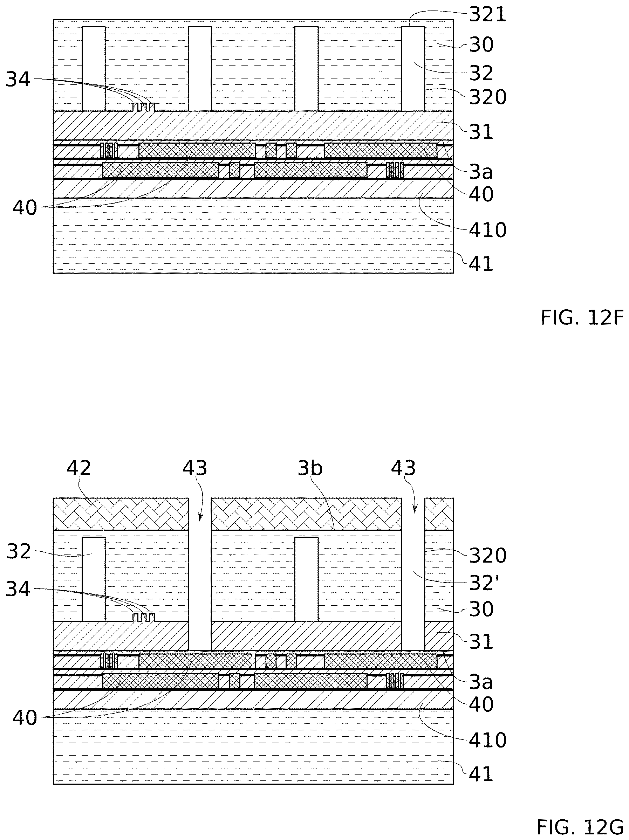

Selon un premier exemple, comme illustré par la figure 12A, 12E et 12F, à partir de la surface arrière 3b du substrat 3, la première couche 30 peut être gravée jusqu'à affleurer, ou dépasser la paroi de fond 321 des vias 32. La paroi de fond 321 des vias 32 est ainsi exposée. Pour cela, la première couche 30 peut être amincie et gravée par une gravure sélective du matériau de la première couche 30 par rapport au matériau diélectrique des parois 320, 321. Selon l'exemple illustré en figure 12A, la gravure peut par exemple être une gravure sélective du silicium par rapport à la silice SiO₂ en gravure ionique réactive utilisant un précurseur tel que SF₆. Par gravure « sélective d'un matériau A par rapport à un matériau B » on entend que la vitesse de gravure du matériau A est 10 et de préférence 100 fois supérieure à celle du matériau B. On peut également envisager la réalisation d'un amincissement mécanique partiel du substrat 3 terminé par une gravure plasma ou chimique sélective.

La paroi en matériau diélectrique peut ensuite être gravée sélectivement par rapport au matériau de la première couche 30, pour déboucher dans le via 32.

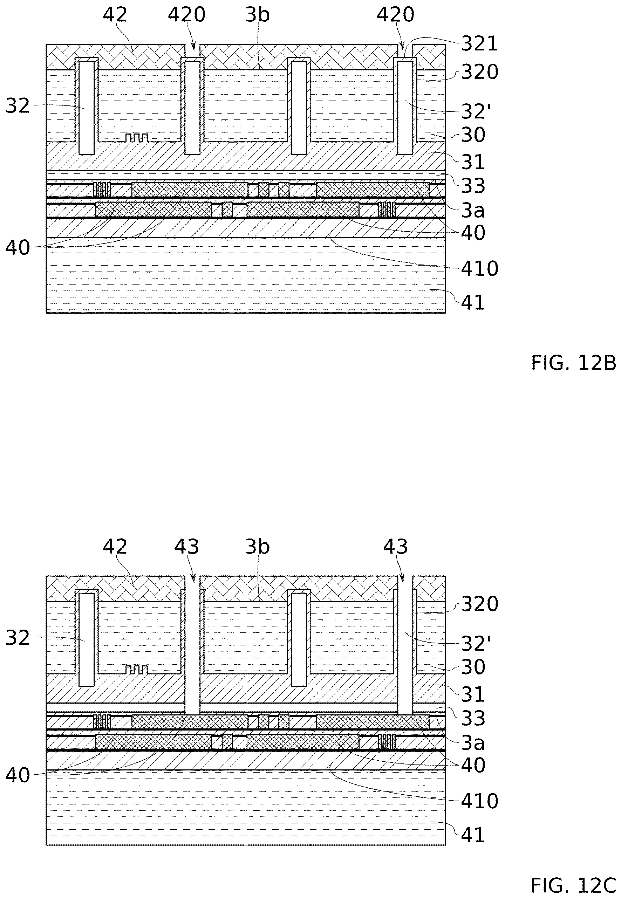

Si l'on souhaite ne graver puis ne remplir qu'une partie des vias 32, notamment lorsque le substrat 3 est un substrat générique comprenant une matrice de vias 32, le procédé peut comprendre une sélection de vias à graver 32'. Comme par exemple illustré par les figures 12B et 12G, un masque 42 peut être déposé sur la surface arrière 3b du substrat 3. Ce masque 42 peut comprendre des ouvertures 420 situées à l'aplomb des vias à graver 32'. Les paroi 321 peuvent ensuite être gravées par l'ouverture, pour déboucher dans les vias 32.

Que l'on grave tout ou partie des vias 32, la gravure peut être poursuivie pour former au moins une cavité 43, par exemple une cavité de raccordement électrique 43 s'étendant depuis le via 32 jusqu'à la portion 40 située en dessous du via 32, comme par exemple illustré en figures 12C et 12G. Dans la suite, on considère à titre non-limitatif que plusieurs cavités 43 sont formées. Par exemple, la gravure du matériau diélectrique au niveau de la paroi 321 peut être une gravure ionique réactive. La gravure du matériau semi-conducteur au niveau de la paroi 321 peut être similaire à celle faite pour graver la couche 30.

Lorsque les parois des vias 32' à graver ne sont pas en matériau diélectrique, le procédé peut comprendre la formation d'une couche diélectrique au niveau au moins de la paroi latérale 320, selon les modalités précédemment décrites en référence au procédé de fabrication du substrat 3. Cet exemple peut être illustré par la figure 12H.

Une fois les cavités 43 formées, le procédé peut comprendre d'un organe électriquement conducteur ou semi-conducteur 45. Cet organe 45 peut être à base ou fait d'un matériau métallique 45, par exemple du cuivre électrolytique ou du tungstène CVD. En alternative, cet organe 5 peut être à base ou fait d'un matériau semi-conducteur, par exemple du poly-Si. Le dépôt peut être configuré de façon à remplir ces cavités 43 du matériau métallique pour former une interconnexion électrique ou une portion de dispositif 4, comme par exemple illustré par la figure 12D. Le dépôt peut en outre être configuré de façon à en outre recouvrir par une couche métallique ou semi-conductrice 46 au moins une portion de la surface exposée arrière 3b du substrat 3.

Entre la formation des cavités 43 et le dépôt de l'organe 45, le procédé peut comprendre au moins l'un parmi :
- le retrait du masque 42,
- une passivation de la surface arrière 3b exposée du substrat 3, par exemple par formation d'une couche de matériau diélectrique 44, aussi appelée couche de passivation 44. Cette formation peut être faite par dépôt d'un matériau diélectrique, par exemple comme décrit précédemment,
- une gravure des cavités 43 de façon à retirer une éventuelle couche d'oxyde qui se serait formé au fond de la cavité, notamment lors de la formation de la couche de passivation 44. Cette éventuelle couche d'oxyde peut en effet limiter la reprise de contact électrique sur la portion 40.

Selon un deuxième exemple illustré par les figures 13A à 13C, le masque 42 peut être d'abord déposé sur la surface arrière 3b du substrat 3. Ce masque 42 peut comprendre des ouvertures 420 situées à l'aplomb des vias 32. Si l'on souhaite ne graver puis métalliser qu'une partie des vias 32, notamment lorsque le substrat 3 est un substrat générique comprenant une matrice de vias 32, la sélection de vias à graver 32' peut être faite par la disposition des ouvertures 420 au-dessus des vias à graver 32'.

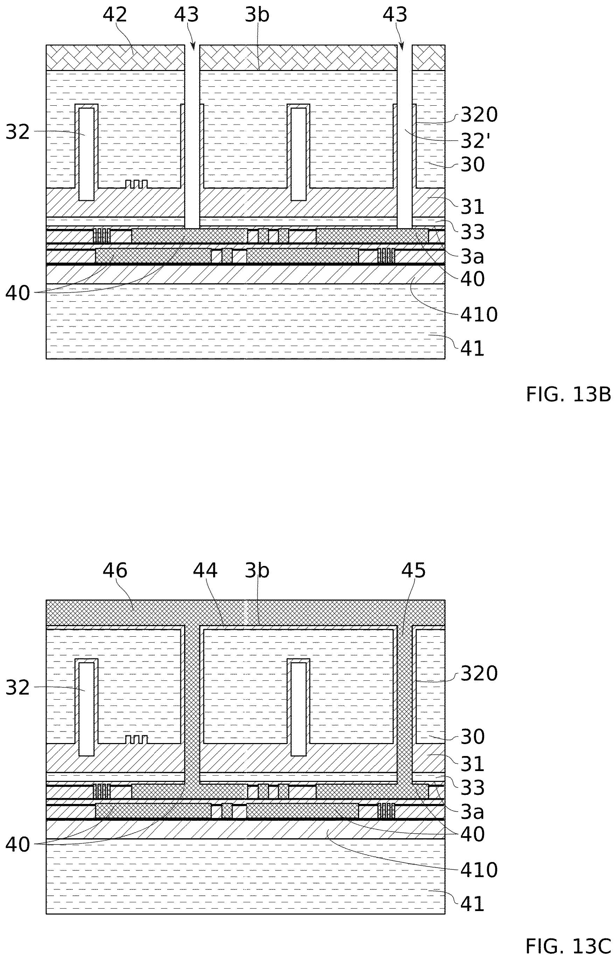

La première couche 30 peut être gravée par les ouvertures 420 jusqu'à affleurer, voire dépasser la paroi de fond 321 des vias. La gravure peut être poursuivie pour former au moins une cavité 43 s'étendant depuis le via 32 jusqu'à la portion métallique 40 située en dessous du via 32, comme par exemple illustré en figure 13B. Ici aussi, on considère à titre non-limitatif que plusieurs cavités 43 sont formées. Cette étape de gravure peut être une gravure ionique réactive.

Les étapes subséquentes peuvent ensuite être réalisées comme précédemment décrit, comme l'illustre à titre d'exemple la figure 13C. La couche 44 passive alors également le haut des cavités 43, en continuité de la paroi latérale 320.

Cet exemple de réalisation est également applicable lorsque les vias 32' ne présentent pas de paroi en matériau diélectrique. Comme précédemment décrit, le procédé peut comprendre la formation d'une couche diélectrique au niveau au moins de la paroi latérale 320 après l'ouverture des vias à graver 32'.

Lorsque le substrat 3 comprend des rainures 35, les deux exemples précédemment décrits peuvent s'appliquer. Les figures 14A à 14F illustrent le premier exemple précédemment décrit. Selon l'un ou l'autre de ces exemples, afin de ne pas remplir les rainures de l'organe conducteur ou semi-conducteur, les ouvertures 420 du masque 42 peuvent être disposées de façon à ne pas permettre la gravure des rainures 35. Plus particulièrement le masque peut recouvrir la surface arrière 3b du substrat à l'aplomb des rainures 35, comme illustré par exemple en figure 14D. Lors des étapes subséquentes à la formation des cavités 43, les rainures 35 restent de préférence closes et ne sont donc pas remplies par l'organe 45.

Suite au dépôt d'une couche métallique 46 sur la surface arrière 3b du substrat, quel que soit l'exemple de réalisation précédemment décrit, le procédé peut comprendre une réalisation de motifs 46' dans cette couche métallique 46, par exemple pour délimiter des interconnexions différentes. Cela peut être illustré à titre d'exemple par la figure15. Cette réalisation de motif peut être faite par masquage, suivie par exemple d'une gravure ionique ou par gravure par faisceau ionique ou par gravure humide.

Le procédé peut comprendre en alternative ou en complément à cette réalisation de motifs 46', une passivation 47 de la surface arrière 3b du substrat, comme l'illustre à titre d'exemple la figure 16. Cette passivation peut être faite par dépôt d'un composé organique telle qu'une résine photosensible de construction, par exemple de type polyimide ou polymère de benzocyclobutène.

Comme l'illustre par exemple la figure 16, le procédé peut en outre comprendre une métallisation 48 dite UBM (de l'anglais *Under Bump Metallization,* que l'on peut traduire par métallisation sous bosse) de façon à connecter les interconnexions électriques obtenues et le boitier 5 illustré en figure 1.

Une fois les étapes de fabrication se déroulant en surface arrière 3b du substrat 3 terminées, le support 41 peut être démonté comme l'illustre le passage de la figure 16 à la figure 17.

Au vu de la description qui précède, il apparaît clairement que l'invention propose un substrat, son procédé de fabrication et un procédé de fabrication d'un dispositif microélectronique permettant de faciliter la fabrication de vias dans un dispositif microélectronique.

Dans les exemples décrits, le matériau semi-conducteur est en silicium. Notons que l'invention peut tout à fait s'appliquer à d'autres semi-conducteurs mono ou polycristallins, éventuellement dopés, et notamment au semi-conducteurs Si, Ge, SiGe, SiC, matériau III-V (par exemple AIN, GaN, InN, InGaAs, GaP, InP, InAs, AsGa...), et matériau II-VI. Le matériau diélectrique peut être un oxyde ou un nitrure de semi-conducteur, par exemple SiO₂, SiN, Al₂O₃. Le matériau piézoélectrique peut à titre d'exemple être le tantalate de lithium (LiTaO₃), le niobate de lithium (LiNbO₃), le niobate de potassium-sodium (KₓNa₁₋ₓNbO₃ ou KNN), le titanate de baryum (BaTiO₃), le quartz, le titano-zirconate de plomb (PZT), un composé de niobate de plomb-magnésium et de titanate de plomb (PMN-PT), l'oxide de zinc (ZnO), le nitrure d'aluminium (AIN) ou le nitrure d'aluminium et de scandium (AIScN), d'autres matériaux pouvant naturellement être envisagés.

## Revendications

1. Substrat (3) comprenant :
• une première couche (30) à base d'un matériau semi-conducteur,
• une deuxième couche (31) surmontant la première couche,
le substrat (3) comprenant une pluralité de vias étant des trous d'interconnexion (32) creux enterrés s'étendant depuis la deuxième couche (31) sur une portion de la première couche (30), chaque via (32) étant délimité par une paroi latérale (320), une paroi de fond (321), et une paroi supérieure (322) opposée à la paroi de fond (321), chaque via (32) présentant au moins une dimension transversale inférieure ou égale à 30 µm.

2. Substrat selon la revendication précédente, dans lequel au moins la paroi de fond (321) et la paroi latérale (320) sont en matériau diélectrique.

3. Substrat selon l'une quelconque des revendications précédentes, dans lequel la deuxième couche (31) est une couche à base, et de préférence faite, d'un matériau choisi parmi un matériau diélectrique, par exemple un oxyde, un matériau semi-conducteur ou un matériau piézoélectrique.

4. Substrat selon l'une quelconque des revendications précédentes, dans lequel au moins une partie des vias (32), et de préférence chaque via (32), présente un rapport de forme supérieur ou égal à 10, de dimensions la plus longue orientée suivant une dimension en épaisseur des première (30) et deuxième (31) couches.

5. Substrat (3) selon l'une quelconque des revendications précédentes, dans lequel la pluralité de vias (32) forme une matrice périodique et dans lequel les vias (32) sont séparés deux à deux par un pas constant suivant au moins une direction du plan d'extension principale des première et deuxième couches, le pas est compris entre 50 µm et 300 µm, de préférence entre 100 µm et 200 µm.

6. Substrat (3) selon l'une quelconque des revendications précédentes, dans lequel au moins un via (32) sur au moins une portion d'une dimension longitudinale dudit via (32), est intégralement entouré par une rainure (35) s'étendant depuis la deuxième couche (31) sur une portion de la première couche (30).

7. Procédé de fabrication du substrat (3) selon l'une quelconque des revendications précédentes, comprenant :
• une fourniture d'un sous-substrat support (1) comprenant au moins une première couche (10) à base d'un matériau semi-conducteur, le sous-substrat support (1) présentant une surface exposée (1a),
• une gravure d'une pluralité de vias étant des trous d'interconnexion (32) de sorte que les vias (32) s'étendent depuis la surface exposée (1a) sur une portion de la première couche (10), chaque via étant délimité par une paroi latérale (320) et une paroi de fond (321), chaque via (32) présentant au moins une dimension transversale inférieure ou égale à 30 µm,
• une fourniture d'un sous-substrat donneur (2) comprenant une couche superficielle (20, 21) présentant une surface exposée (2a),
• un assemblage du sous-substrat support (1) et du sous-substrat donneur (2) par leurs surfaces exposées (1a, 2a), de façon à recouvrir les vias (32), chaque via étant alors délimité par la paroi latérale (320), la paroi de fond (321), et une paroi supérieure (322) opposée à la paroi de fond (321).

8. Procédé selon la revendication précédente, dans lequel suite à la gravure de la pluralité de vias (32) et de préférence avant l'assemblage du sous-substrat support (1) et du sous-substrat donneur (2), le procédé comprend, pour chaque via (32), une formation d'un matériau diélectrique au niveau au moins de la paroi de fond (321) et de la paroi latérale (320).

9. Procédé selon la revendication précédente, dans lequel la formation d'un matériau diélectrique au niveau au moins de la paroi de fond (321) et de la paroi latérale (320) de la pluralité de vias (32) comprend :
• une oxydation thermique de façon à oxyder le matériau semi-conducteur de la première couche (10) au niveau au moins de la paroi de fond (321) et de la paroi latérale (320), et/ou
• un dépôt du matériau diélectrique au niveau au moins de la paroi de fond (321) et de la paroi latérale (320).

10. Procédé selon l'une quelconque des trois revendications précédentes, dans lequel la couche superficielle (20, 21) du sous-substrat donneur est une couche à base, et de préférence faite, d'un matériau choisi parmi un matériau diélectrique, par exemple un oxyde, un matériau semi-conducteur ou un matériau piézoélectrique.

11. Procédé selon l'une quelconque des quatre revendications précédentes, dans lequel :
• le sous-substrat support (1) comprend en outre une couche superficielle (11) à base, et de préférence faite, d'un matériau diélectrique, par exemple un oxyde, surmontant la première couche (10), la couche superficielle présentant la surface exposée (1a), et/ou
• la couche superficielle (21) du sous-substrat donneur est une couche à base, et de préférence faite, d'un matériau diélectrique, par exemple un oxyde, surmontant une couche (20) à base d'un matériau choisi parmi un matériau semi-conducteur ou un matériau piézoélectrique.

12. Procédé de fabrication d'un dispositif microélectronique (4) comprenant :
• une fourniture d'un substrat (3) selon l'une quelconque des revendications 1 à 6 ou d'un substrat (3) fabriqué par le procédé selon l'une quelconque des revendications 7 à 11, présentant une surface exposée avant (3a) et une surface exposée arrière (3b),
• une formation d'au moins une portion de couche (40) du dispositif (4) par un dépôt, sur la surface exposée avant (3a) du substrat (3), de ladite portion, et/ou une gravure de la surface exposée avant (3a) du substrat (3), configurée de façon à former ladite portion,
• au niveau d'au moins un via, une gravure par la surface exposée arrière (3b) du substrat (3), dans laquelle une paroi parmi la paroi supérieure (322) et la paroi de fond (321) de l'au moins un via est gravée de façon à déboucher dans le via (32), puis poursuivre la gravure pour atteindre l'au moins une portion de couche (40) du dispositif (4), pour former une cavité (43),
• le dépôt d'un organe électriquement conducteur ou semi-conducteur (45) de façon à remplir la cavité (43).

13. Procédé selon la revendication précédente, comprenant préalablement à la gravure par la surface exposée arrière (3b) du substrat (3), une sélection d'au moins un via à graver (32') parmi la pluralité de vias (32), uniquement une partie de la pluralité de vias (32) étant sélectionnée comme via à graver (32'), la sélection de l'au moins un via à graver comprenant :
• l'application, sur la surface exposée arrière (3b) du substrat (3), d'un masque (42) comprenant des ouvertures (420) située à l'aplomb de l'au moins un via à graver (32'), et
• une gravure de la première couche (30) de façon à atteindre ladite paroi de l'au moins un via à graver (32').

14. Procédé selon la revendication précédente, dans lequel la sélection de l'au moins un via à graver (32') comprend l'application du masque (42) puis la gravure de la première couche (30) à travers les ouvertures (420) du masque (42).

15. Procédé selon la revendication 13, dans lequel la sélection de l'au moins un via à graver (32') comprend la gravure de la première couche (30) de façon à atteindre ladite paroi de l'au moins un via à graver (32'), puis l'application du masque (42).

16. Procédé selon l'une quelconque des quatre revendications précédentes, dans lequel le dépôt de l'organe électriquement conducteur ou semi-conducteur (45) est configuré de façon à en outre recouvrir par une couche électriquement conductrice ou semi-conductrice (46) au moins une portion de la surface exposée arrière (3b) du substrat (3),

17. Procédé selon l'une quelconque des cinq revendications précédentes, dans lequel le procédé comprend :
• entre la formation de l'au moins une portion de couche (40) du dispositif (4), et la gravure par la surface exposée arrière (3b) du substrat (3), le montage d'un support (41) sur la surface exposée avant (3a) du substrat (3), et
• après le dépôt de l'organe électriquement conducteur ou semi-conducteur (45) de façon à remplir la cavité (43), le démontage du support (41).

## Patentansprüche

1. Substrat (3), umfassend:
• eine erste Schicht (30) auf Basis eines Halbleitermaterials,
• eine zweite Schicht (31), die auf der ersten Schicht überlagert ist,
wobei das Substrat (3) eine Vielzahl von Vias umfasst, die hohle, vergrabene Verbindungslöcher (32) sind, die sich von der zweiten Schicht (31) auf einem Abschnitt der ersten Schicht (30) erstrecken, wobei jedes Via (32) von einer Seitenwand (320), einer Bodenwand (321) und einer oberen Wand (322), die der Bodenwand (321) entgegengesetzt ist, begrenzt ist, wobei jedes Via (32) mindestens ein Quermaß kleiner oder gleich 30 µm aufweist.

2. Substrat nach dem vorstehenden Anspruch, wobei mindestens die Bodenwand (321) und die Seitenwand (320) aus dielektrischem Material bestehen.

3. Substrat nach einem der vorstehenden Ansprüche, wobei die zweite Schicht (31) eine Schicht basierend auf einem Material ist und bevorzugt daraus hergestellt ist, das aus einem dielektrischen Material ausgewählt ist, beispielsweise einem Oxid, einem Halbleitermaterial oder einem piezoelektrisches Material.

4. Substrat nach einem dem vorstehenden Ansprüche, wobei mindestens ein Teil der Vias (32) und bevorzugt jedes Via (32) ein Seitenverhältnis größer oder gleich 10 aufweist, wobei die längste Abmessung entlang einer Dickenabmessung der ersten (30) und zweiten (31) Schicht ausgerichtet ist.

5. Substrat (3) nach einem der vorstehenden Ansprüche, wobei die Vielzahl von Vias (32) eine periodische Matrix bildet und wobei die Vias (32) zu je zwei durch einen konstanten Abstand entlang mindestens einer Richtung der Hauptausdehnungsebene der ersten und zweiten Schicht getrennt sind, wobei der Abstand zwischen 50 µm und 300 µm, bevorzugt zwischen 100 µm und 200 µm liegt.

6. Substrat (3) nach einem der vorstehenden Ansprüche, wobei mindestens ein Via (32) auf mindestens einem Abschnitt eine Längsabmessung des Vias (32) integral von einer Rille (35) umgeben ist, die sich von der zweiten Schicht (31) auf einem Abschnitt der ersten Schicht (30) erstreckt.

7. Verfahren zur Herstellung des Substrats (3) nach einem der vorstehenden Ansprüche, umfassend:
• eine Bereitstellung eines Trägeruntersubstrats (1), das mindestens eine erste Schicht (10) auf Basis eines Halbleitermaterials umfasst, wobei das Trägeruntersubstrat (1) eine freiliegende Oberfläche (1a) aufweist,
• eine Ätzung einer Vielzahl von Vias, die Verbindungslöcher (32) derart sind, dass sich die Vias (32) von der freigelegten Oberfläche (1a) auf einem Abschnitt der ersten Schicht (10) erstrecken, wobei jedes Via von einer Seitenwand (320) und einer Bodenwand (321) begrenzt ist, wobei jedes Via (32) mindestens ein Quermaß kleiner oder gleich 30 µm aufweist,
• eine Bereitstellung eines Donor-Untersubstrats (2), das eine oberflächliche Schicht (20, 21) umfasst, die eine freigelegte Oberfläche (2a) aufweist,
• ein Zusammenfügen des Trägeruntersubstrats (1) und des Donor-Untersubstrats (2) an ihren freigelegten Oberflächen (1a, 2a) derart, dass die Vias (32) bedeckt sind, wobei jedes Via dabei von der Seitenwand (320), der Bodenwand (321) und einer oberen Wand (322), die der Bodenwand (321) entgegengesetzt ist, begrenzt ist.

8. Verfahren nach dem vorstehenden Anspruch, wobei im Anschluss an die Ätzung der Vielzahl von Vias (32) und bevorzugt vor dem Zusammenfügen des Trägeruntersubstrats (1) und des Donor-Untersubstrats (2) das Verfahren für jedes Via (32) ein Bilden eines dielektrischen Materials auf der Ebene mindestens der Bodenwand (321) und der Seitenwand (320) umfasst.

9. Verfahren nach dem vorstehenden Anspruch, wobei das Bilden eines dielektrischen Materials auf der Ebene mindestens der Bodenwand (321) und der Seitenwand (320) der Vielzahl von Vias (32) Folgendes umfasst:
• eine thermische Oxidation derart, dass das Halbleitermaterial der ersten Schicht (10) auf der Ebene mindestens der Bodenwand (321) und der Seitenwand (320) oxidiert wird, und/oder
• eine Abscheidung des dielektrischen Materials auf der Ebene mindestens der Bodenwand (321) und der Seitenwand (320).

10. Verfahren nach einem der drei vorstehenden Ansprüche, wobei die oberflächlichen Schicht (20, 21) des Donor-Untersubstrats eine Schicht basierend auf einem Material ist und bevorzugt daraus hergestellt ist, das aus einem dielektrischen Material, beispielsweise einem Oxid, einem Halbleitermaterial oder einem piezoelektrischen Material ausgewählt ist.

11. Verfahren nach einem der vier vorstehenden Ansprüche, wobei:
• das Trägeruntersubstrat (1) außerdem eine oberflächlichen Schicht (11) eine Schicht basierend auf einem Material ist und bevorzugt daraus hergestellt ist, aus einem dielektrischen Material, beispielsweise einem Oxid, das auf der ersten Schicht (10) überlagert ist, wobei die oberflächliche Schicht die freigelegte Oberfläche (1a) aufweist, und/oder
• die oberflächliche Schicht (21) des Donor-Untersubstrats eine Schicht auf Basis eines Materials ist und bevorzugt daraus hergestellt ist, aus einem dielektrischen Material, beispielsweise einem Oxid, das auf einer Schicht (20) auf Basis eines Materials überlagert ist, das aus einem Halbleitermaterial oder einem piezoelektrischen Material ausgewählt ist.

12. Herstellungsverfahren einer mikroelektronischen Vorrichtung (4), umfassend:
• ein Bereitstellen eines Substrats (3) nach einem der Ansprüche 1 bis 6 oder eines Substrats (3), das durch das Verfahren nach einem der Ansprüche 7 bis 11 gefertigt wird, das eine freigelegte vordere Oberfläche (3a) und eine freigelegte hintere Oberfläche (3b) aufweist,
• ein Bilden mindestens eines Schichtabschnitts (40) der Vorrichtung (4) durch ein Abscheiden auf der freigelegten vorderen Oberfläche (3a) des Substrats (3) des Abschnitts und/oder einer Ätzung der freigelegten vorderen Oberfläche (3a) des Substrats (3), die dazu konfiguriert ist, den Abschnitt zu bilden,
• eine Ätzung durch die freigelegte hintere Oberfläche (3b) des Substrats (3) auf der Ebene mindestens eines Vias, in der eine der oberen Wand (322) und der Bodenwand (321) des mindestens einen Vias derart geätzt wird, dass sie in das Via (32) mündet, wonach das Ätzen fortgesetzt wird, um mindestens einen Schichtabschnitt (40) der Vorrichtung (4) zu erreichen, um einen Hohlraum (43) zu bilden,
• das Abscheiden eines elektrisch leitfähigen oder halbleitenden Elements (45) derart, dass der Hohlraum (43) gefüllt wird.

13. Verfahren nach dem vorstehenden Anspruch, das vor der Ätzung durch die freigelegte hintere Oberfläche (3b) des Substrats (3) eine Auswahl mindestens eines zu ätzenden Vias (32') aus der Vielzahl von Vias (32) umfasst, wobei nur ein Teil der Vielzahl von Vias (32) als das zu ätzende wir (32') ausgewählt wird, wobei die Auswahl des mindestens einen zu ätzenden Vias Folgendes umfasst:
• Aufbringen auf der freigelegten hinteren Oberfläche (3b) des Substrats (3) einer Maske (42), die Öffnungen (420) umfasst, die lotrecht zu dem mindestens einen zu ätzenden Via (32') liegen, und
• eine Ätzung der ersten Schicht (30) derart, dass die Wand des mindestens einen zu ätzenden Vias (32') erreicht wird.

14. Verfahren nach dem vorstehenden Anspruch, wobei die Auswahl des mindestens einen zu ätzenden Vias (32') das Aufbringen der Maske (42) und dann das Gravieren der ersten Schicht (30) durch die Öffnungen (420) der Maske (42) umfasst.

15. Verfahren nach Anspruch 13, wobei die Auswahl des mindestens einen zu ätzenden Vias (32') das Ätzen der ersten Schicht (30) derart umfasst, dass die Wand des mindestens einen zu ätzenden Vias (32') erreicht wird, gefolgt vom Aufbringen der Maske (42).

16. Verfahren nach einem der vier vorstehenden Ansprüche, wobei das Abscheiden des elektrisch leitfähigen oder halbleitenden Elements (45) derart konfiguriert wird, dass außerdem mindestens ein Teil der freigelegten hinteren Oberfläche (3b) des Substrats (3) durch eine elektrisch leitfähige oder Halbleiterschicht (46) bedeckt wird.

17. Verfahren nach einem der fünf vorstehenden Ansprüche, wobei das Verfahren Folgendes umfasst:
• zwischen dem Bilden des mindestens einen Schichtabschnitts (40) der Vorrichtung (4) und dem Ätzen durch die freigelegte hintere Oberfläche (3b) des Substrats (3), Montage eines Trägers (41) auf der freigelegten vorderen Oberfläche (3a) des Substrats (3), und
• nach Abscheiden des elektrisch leitfähigen oder halbleitenden Elements (45) zum Füllen des Hohlraums (43), Demontage des Trägers (41).

## Claims

1. Substrate (3) comprising:
• a first layer (30) based on a semiconductive material,
• a second layer (31) surmounting the first layer,
the substrate (3) comprising a plurality of buried vias (32) being buried hollow interconnecting holes extending from the second layer (31) over a portion of the first layer (30), each via (32) being delimited by a side wall (320), a bottom wall (321), and an upper wall (322) opposite the bottom wall (321), each via (32) having at least one transverse dimension less than or equal to 30µm.

2. Substrate according to the preceding claim, wherein at least the bottom wall (321) and the side wall (320) are made of dielectric material.

3. Substrate according to any one of the preceding claims, wherein the second layer (31) is a layer with the basis, and preferably made, of a material chosen from among a dielectric material, for example, an oxide, a semiconductive material or a piezoelectric material.

4. Substrate according to any one of the preceding claims, wherein at least some of the vias (32), and preferably each via (32), has an aspect ratio greater than or equal to 10, of longer dimensions oriented along a dimension in thickness of the first (30) and second (31) layers.

5. Substrate (3) according to any one of the preceding claims, wherein the plurality of vias (32) forms a periodic matrix and wherein the vias (32) are separated in pairs by a constant pitch along at least one direction of the main extension plane of the first and second layers, the pitch is between 50µm and 300µm, preferably between 100µm and 200µm.

6. Substrate (3) according to any one of the preceding claims, wherein at least one via (32) over at least one portion of a longitudinal dimension of said via (32), is fully surrounded by a groove (35) extending from the second layer (31) over a portion of the first layer (30).

7. Method for manufacturing the substrate (3) according to any one of the preceding claims, comprising:
• a provision of a support sub-substrate (1) comprising at least one first layer (10) based on a semiconductive material, the support sub-substrate (1) having an exposed surface (1a),
• an etching of a plurality of vias (32) being interconnecting hole such that the vias (32) extend from the exposed surface (1a) over a portion of the first layer (10), each via being delimited by a side wall (320) and a bottom wall (321), each via (32) having at least one transverse dimension less than or equal to 30µm,
• a provision of a donor sub-substrate (2) comprising a superficial layer (20, 21) having an exposed surface (2a),
• an assembly of the support sub-substrate (1) and of the donor sub-substrate (2) by their exposed surfaces (1a, 2a), so as to cover the vias (32), each via thus being delimited by the side wall (320), the bottom wall (321), and an upper wall (322) opposite the bottom wall (321).

8. Method according to the preceding claim, wherein, following the etching of the plurality of vias (32) and preferably before the assembly of the support sub-substrate (1) and of the donor sub-substrate (2), the method comprises, for each via (32), a formation of a dielectric material at at least the bottom wall (321) and the side wall (320).

9. Method according to the preceding claim, wherein the formation of a dielectric material at at least the bottom wall (321) and the side wall (320) of the plurality of vias (32) comprises:
• a thermal oxidation so as to oxidise the semiconductive material of the first layer (10) at at least the bottom wall (321) and the side wall (320), and/or
• a deposition of the dielectric material at at least the bottom wall (321) and the side wall (320).

10. Method according to any one of the three preceding claims, wherein the superficial layer (20, 21) of the donor sub-substrate is a layer with the basis, preferably made, of a material chosen from among a dielectric material, for example, an oxide, a semiconductive material or a piezoelectric material.

11. Method according to any one of the four preceding claims, wherein:
• the support sub-substrate (1) further comprises a superficial layer (11) with the basis, and preferably made, of a dielectric material, for example, an oxide, surmounting the first layer (10), the superficial layer having the exposed surface (1a), and/or
• the superficial layer (21) of the donor sub-substrate is a layer with the basis, and preferably made, of a dielectric material, for example, an oxide, surmounting a layer (20) based on a material chosen from among a semiconductive material or a piezoelectric material.

12. Method for manufacturing a microelectronic device (4) comprising:
• a provision of a substrate (3) according to any one of claims 1 to 6 or of a substrate (3) manufactured by the method according to any one of claims 7 to 11, having a front exposed surface (3a) and a back exposed surface (3b),
• a formation of at least one layer portion (40) of the device (4) by a deposition, on the front exposed surface (3a) of the substrate (3), of said portion, and/or an etching of the front exposed surface (3a) of the substrate (3), configured so as to form said portion,
• at at least one via, an etching by the back exposed surface (3b) of the substrate (3), in which a wall from among the upper wall (322) and the bottom wall (321) of the at least one via is etched, so as to open into the via (32), then continue the etching to reach the at least one layer portion (40) of the device (4), to form a cavity (43),
• the deposition of an electrically conductive or semiconductive member (45), so as to fill the cavity (43).

13. Method according to the preceding claim, comprising, prior to the etching by the back exposed surface (3b) of the substrate (3), a selection of at least one via (32') to be etched from among the plurality of vias (32), only some of the plurality of vias (32) being selected as the via (32') to be etched, the selection of the at least one via to be etched comprising:
• the application, on the back exposed surface (3b) of the substrate (3), of a mask (42) comprising openings (420) located in vertical alignment with the at least one via (32') to be etched, and
• an etching of the first layer (30), so as to reach said wall of the at least one via (32') to be etched.

14. Method according to the preceding claim, wherein the selection of the at least one via (32') to be etched comprises the application of the mask (42), then the etching of the first layer (30) through the openings (420) of the mask (42).

15. Method according to claim 13, wherein the selection of the at least one via (32') to be etched comprises the etching of the first layer (30), so as to reach said wall of the at least one via (32') to be etched, then the application of the mask (42).

16. Method according to any one of the four preceding claims, wherein the deposition of the electrically conductive or semiconductive member (45) is configured so as to further cover, by an electrically conductive or semiconductive layer (46), at least one portion of the back exposed surface (3b) of the substrate (3).

17. Method according to any one of the five preceding claims, wherein the method comprises:
• between the formation of the at least one layer portion (40) of the device (4), and the etching by the back exposed surface (3b) of the substrate (3), the mounting of a support (41) on the front exposed surface (3a) of the substrate (3), and
• after the deposition of the electrically conductive or semiconductive member (45), so as to fill the cavity (43), the dismounting of the support (41).
